(19) Europäisches Patentamt
European Patent Office
Office européen des brevets

(11) EP 1 946 387 B1

(12) FASCICULE DE BREVET EUROPEEN

(45) Date de publication et mention
de la délivrance du brevet:
**11.01.2017 Bulletin 2017/02**

(21) Numéro de dépôt: **06819390.3**

(22) Date de dépôt: **10.11.2006**

(51) Int Cl.:
***H01L 31/0236*** *(2006.01)*   ***G02B 6/42*** *(2006.01)*

(86) Numéro de dépôt international:
**PCT/EP2006/068334**

(87) Numéro de publication internationale:
**WO 2007/054560 (18.05.2007 Gazette 2007/20)**

(54) **STRUCTURE OPTIQUE DE LOCALISATION D'UN CHAMP ELECTRO-MAGNETIQUE ET DISPOSITIF DETECTEURS OU EMETTEURS COMPRENANT UNE TELLE STRUCTURE**

OPTISCHE STRUKTUR ZUM LOKALISIEREN EINES ELEKTROMAGNETISCHEN FELDES UND DETEKTOR ODER EMITTEREINRICHTUNG MIT EINER SOLCHEN STRUKTUR

OPTICAL STRUCTURE FOR LOCALIZING AN ELECTROMAGNETIC FIELD AND DETECTOR OR EMITTER DEVICE COMPRISING SUCH A STRUCTURE

(84) Etats contractants désignés:
**DE FR GB SE**

(30) Priorité: **10.11.2005 FR 0511463**

(43) Date de publication de la demande:
**23.07.2008 Bulletin 2008/30**

(73) Titulaire: **Société Française de Détecteurs
Infrarouges -
SOFRADIR
91120 Palaiseau (FR)**

(72) Inventeurs:
• **CARRAS, Mathieu**
  **F-92120 Montrouge (FR)**
• **DE ROSSI, Alfredo**
  **F-75014 Paris (FR)**
• **SCHNELL, Jean-Philippe**
  **F-75007 Paris (FR)**

(74) Mandataire: **Cabinet Laurent & Charras
Le Contemporain
50 Chemin de la Bruyère
69574 Dardilly Cedex (FR)**

(56) Documents cités:
**FR-A- 2 863 774    US-A- 5 455 178**

• **DMITRUK N L ET AL: "Ultraviolet responsivity control in Schottky barrier heterostructures with textured interface" THIN SOLID FILMS, ELSEVIER-SEQUOIA S.A. LAUSANNE, CH, vol. 364, no. 1-2, mars 2000 (2000-03), pages 280-283, XP004195111 ISSN: 0040-6090**

EP 1 946 387 B1

**EP 1 946 387 B1**

**Description**

La présente invention concerne une structure optique de localisation d'un champ électro-magnétique à proximité d'une zone optique active.

De telles structures optiques sont notamment utilisées dans des photodétecteurs, et notamment dans des photo-détecteurs à puits quantiques, connus sous l'acronyme anglo-saxon QWIP (pour *Quantum Well infrared Photodetector*), fonctionnant dans le moyen infra-rouge, dans le but d'améliorer leur détectivité. Plus précisément, ces structures optiques y sont utilisées pour obtenir une concentration du champ dans la zone active de détection qui peut alors avoir des dimensions sensiblement réduites, pour correspondre à la zone de concentration du champ. En pratique, la zone active du photodétecteur est disposée au voisinage de la structure et centrée sur la zone de concentration (ou de localisation) du champ. On bénéficie alors d'une très nette amélioration du rapport signal sur bruit par rapport à des dispositifs photodétecteurs ne disposant pas de telles structures optiques : la zone active étant plus petite, le bruit photoélectrique qu'elle génère est diminué. La zone active étant adaptée à la zone de concentration du champ, on ne perd rien en signal utile.

La concentration de l'énergie lumineuse sur une surface réduite du photo-détecteur obtenue par ces structures optiques repose sur l'exploitation de phénomènes de localisation du champ proche et des propriétés de certaines ondes de surface appelées plasmons de surface.

De telles structures optiques pour photodétecteurs sont notamment décrites dans le brevet publié FR2863774.

Dans un exemple de réalisation donné dans cette demande, une structure optique correspondante comprend un matériau diélectrique transparent dans la plage spectrale du rayonnement optique. Cette couche est gravée en sorte d'obtenir un relief y=h(x,z) dans un référentiel orthogonal 0xyz, invariant selon 0z et variable selon 0x. Elle est recouverte d'une pellicule de métal. Le profil dans le plan 0xy est tel qu'il peut être défini par une fonction mathématique, qui est la somme des deux fonctions périodiques f et g, f représentant la fonction de couplage entre la lumière incidente sur le photodétecteur et le champ électromagnétique de l'onde excitée en surface, de période spatiale A et g représentant la fonction de localisation de période spatiale ½Λ et qui comporte un défaut dans la périodicité, dans la partie centrale de la structure optique. La phase relative δΛ entre f et g conditionne les propriétés finales de couplage de l'onde de surface. Si on note λ la longueur d'onde moyenne du rayonnement incident, et n l'indice de réfraction moyen de la structure optique, la période A est avantageusement égale à λ/2n pour obtenir un couplage optimal de l'onde d'incidence. La concentration de champ est obtenue dans une zone autour du défaut de périodicité de la structure.

Dans un exemple, des structures optiques correspondantes ont un profil en marches d'escalier ou à facettes. Le profil est obtenu moyennant plusieurs étapes de gravure, le nombre d'étapes dépendant de la complexité du profil à réaliser.

Les étapes de gravure nécessaires à la réalisation de la structure optique décrite dans cette demande de brevet pose des problèmes de réalisation technologique. Notamment, cela entraîne des problèmes de ré-alignement des masques de gravures entre les différentes étapes et de contrôle de la profondeur de gravure, c'est à dire de la hauteur des marches, qui est un paramètre technologique des plus difficiles à contrôler.

En outre, ces structures optiques offrent peu de souplesse de réglage des propriétés de localisation de l'onde électromagnétique sous la structure optique. Notamment, on ne sait pas découpler la décroissance de l'onde selon l'axe 0x et selon l'axe 0y, car le seul degré de liberté dans la structure est la durée des étapes de gravure. Dans les structures optiques obtenues selon ce principe, la phase relative entre les deux réseaux superposés est fixe.

L'invention a pour objet d'améliorer les structures optiques de localisation d'un champ électromagnétique, en rendant leur paramétrage et leur fabrication plus aisés, de manière à améliorer leurs propriétés tout en réduisant les coûts de fabrication et en améliorant la fiabilité. Un autre objet de l'invention est de faciliter le paramétrage de ces structures, pour permettre une application plus large de ces structures optiques, notamment à d'autres dispositifs utilisant des éléments photosensibles, tels que des émetteurs de lumière ou d'électrons.

Un objet de l'invention est ainsi de définir une structure optique offrant plusieurs degrés de liberté pour son paramétrage, de manière à permettre un réglage séparé de différents paramètres, selon les effets de localisation selon les axes 0x et 0y recherchés.

Un autre objet de l'invention, est une structure optique simple à fabriquer, donc aisément intégrable dans un processus de fabrication d'un dispositif optique, et qui s'applique à une plus grande variété de dispositifs photodétecteurs et/ou émetteurs.

Selon l'invention, une structure optique est définie à partir de la répétition périodique d'un motif élémentaire, dont le profil en coupe 0xy, est défini par une forme essentiellement binaire, définie par deux hauteurs relatives, qui définissent une profondeur de gravure (sur l'axe Oy), et quatre paramètres variables sur l'axe 0x. Au premier ordre, on peut décrire le profil du motif élémentaire selon l'invention par les deux fonctions périodiques f et g vues précédemment. Les paramètres du motif sont réglés dans le but d'obtenir les propriétés de couplage et de localisation désirées pour l'application considérée.

Une unique étape technologique permet alors d'obtenir une structure optique aux propriétés requises, à partir du dessin d'un masque de gravure.

Ainsi, en réalisant une zone par réplique d'un motif élémentaire défini selon l'invention, on obtient une structure optique paramétrable, facile à réaliser sur le plan technologique et adaptable aux variétés d'émetteur ou détecteur optique.

L'invention concerne donc un dispositif comprenant au moins un élément optique actif disposé dans un milieu de perméabilité diélectrique positive et, à proximité dudit élément actif, une structure optique comprenant une couche d'un matériau de perméabilité diélectrique négative, ladite couche présentant, repérée dans un référentiel orthogonal 0xyz, une surface ayant un relief y=h(x,z) invariant selon 0z et variable selon 0x, l'axe 0y étant orienté depuis le milieu de perméabilité diélectrique positive vers ladite couche de perméabilité diélectrique négative, ladite surface étant en contact avec ledit milieu de perméabilité diélectrique positive et comprenant une première zone de relief, ayant un profil en coupe selon 0xy qui comprend une répétition périodique d'un motif élémentaire et une deuxième zone de relief symétrique de ladite première zone par rapport à un plan de symétrie parallèle à 0yz, lesdites première et deuxième zones étant séparées par une troisième zone disposée au centre de la structure créant en comparaison des dites première et deuxième zones, un défaut de périodicité de la surface en relief, caractérisé en ce que ledit motif élémentaire est défini par quatre portions successives, une première portion de largeur à mi-hauteur a et une deuxième portion de largeur à mi-hauteur b, une troisième portion de largeur à mi-hauteur c et une quatrième portion de largeur à mi-hauteur d, les première et troisième portions étant sensiblement de même hauteur $h_t$, les deuxième et quatrième portions étant sensiblement de même hauteur $h_d$ différente de $h_t$, avec $h_t$ strictement supérieur à $h_d$ et en ce que a, b, c, d et hg= $h_t$-$h_d$ sont des paramètres du profil choisis tels que :

- chacun est non nul,
- la somme a+b+c+d est égale à la période A et
- au moins a≠c ou b≠d.

L'invention concerne aussi deux dessins préférés du profil, pour les propriétés qu'elles confèrent à la structure, et des applications de la structure optique selon l'invention selon le dispositif à zone active considéré : photo-détecteur, émetteur d'un rayonnement optique ou d'un faisceau d'électrons.

D'autres avantages et caractéristiques de l'invention apparaîtront plus clairement à la lecture de la description qui suit, faite à titre indicatif et non limitatif de l'invention et en référence aux dessins annexés, dans lesquels :

- la figure 1 illustre une portion du profil d'une structure optique selon l'invention ;
- la figure 2 illustre le principe de construction du profil d'une structure optique selon l'invention ;
- la figure 3 représente les deux premiers harmoniques de la série de Fourier complexe qui décrit le profil d'une structure optique selon l'invention ;
- la figure 4 illustre un premier mode de réalisation préféré d'une structure optique selon l'invention ;
- les figures 5a et 5b illustrent un deuxième mode de réalisation préféré d'une structure optique selon l'invention ;
- la figure 6 illustre un dispositif photodétecteur comprenant une structure optique selon l'invention ;
- la figure 7 illustre une variante d'un tel dispositif, applicable avec une structure suivant le premier mode de réalisation préféré ;
- les figures 8a à 8c illustrent un dispositif émetteur d'ondes lumineuses, comprenant une structure optique selon l'invention ;
- la figure 9 illustre un dispositif émetteur d'onde terahertz par conversion de fréquence, comprenant une structure optique selon l'invention ; et
- les figures 10a à 10f illustrent un dispositif à émission de champ comprenant une structure optique selon l'invention.

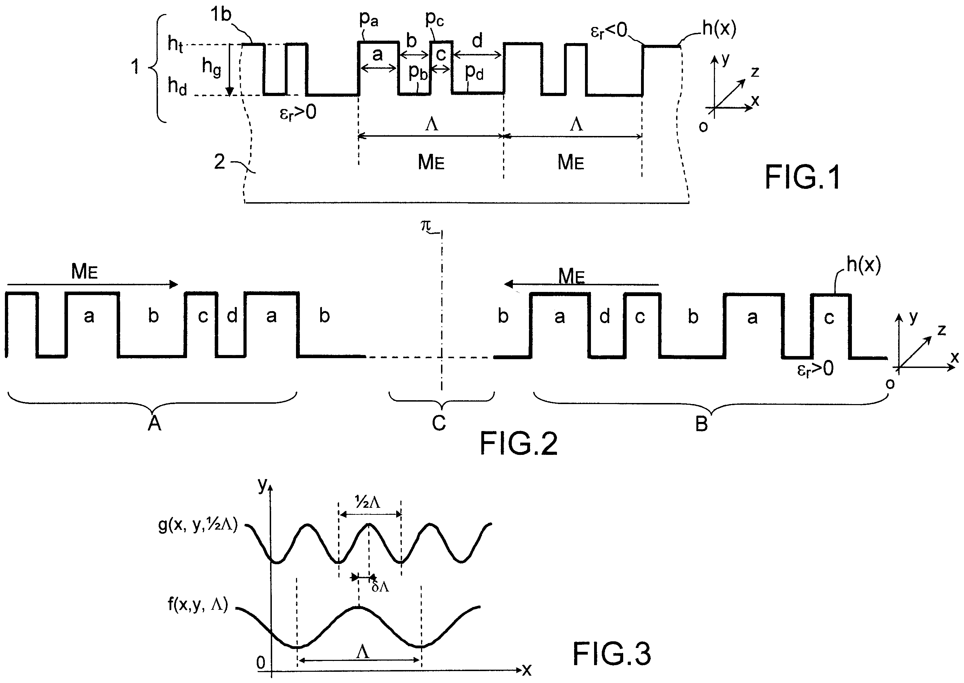

La figure 1 illustre une vue en coupe 0xy d'une portion d'une structure optique 1 selon l'invention. Cette structure optique est disposée en contact avec un milieu 2 de perméabilité diélectrique $\varepsilon_r$ positive. On verra que ce milieu peut être un matériau de type semi-conducteur ou le vide.

Cette structure optique 1 comprend une couche 1 b d'un matériau de perméabilité diélectrique $\varepsilon_r$ négative, tel qu'un métal ou un semi-conducteur dopé.

On choisit un référentiel orthogonal 0xyz, les axes Ox et 0z étant les axes de surface et l'axe 0y, l'axe de hauteur. Par convention dans toutes les figures, l'axe 0y est orienté depuis le milieu 2 de perméabilité diélectrique positive vers la couche 1 b de perméabilité diélectrique négative, soit dans les figures, orienté vers le haut.

La couche 1 b de la structure optique présente une surface ayant un relief y=h(x,z) invariant selon 0z, et variable selon 0x. On note y=h(x) le profil de cette couche dans le plan 0xy. Dans la portion illustrée sur la figure, ce profil correspond à la répétition périodique, à la période Λ, d'un motif élémentaire ME défini selon l'invention. Le motif élémentaire ME a une longueur égale à la période A. Il est invariant selon l'axe Oz. Il peut prendre deux valeurs $h_t$ ou $h_d$ sur l'axe Oy, en fonction de x.

La période A est choisie pour correspondre au domaine spectral opérationnel du dispositif auquel est intégrée la structure, par exemple un photodétecteur. Si on note $\lambda$ la longueur d'onde opérationnelle de détection du photodétecteur, la période A est choisie telle que A. $\eta_{moyen}$ soit sensiblement égal à $\lambda$, où $\eta_{moyen}$ est l'indice de réfraction moyenne de la structure optique.

Comme illustré sur la figure 1, le motif élémentaire ME est défini par quatre paramètres a, b, c et d suivant 0x, et un paramètre hg suivant Oy.

Les paramètres a, b, c, d correspondent à la largeur de quatre portions de droite, une première portion $p_a$ de largeur a et une deuxième portion $p_b$ de largeur b, et une troisième portion $p_c$ de largeur c et une quatrième portion $p_d$ de largeur d. Les première et troisième portions sont sensiblement de même hauteur $h_t$. Les deuxième et quatrième portions sont sensiblement de même hauteur $h_d$ différent de $h_t$. Le paramètre $h_g$ est égal à $h_t$-$h_d$. Les paramètres a, b, c et d du profil sont choisis tels que :

- chacun est non nul,
- leur somme a+b+c+d est égale à la période A et
- ils vérifient la condition : au moins a≠c ou b≠d.

Les paramètres a, b, c et d et $h_g$ du motif ME déterminent les propriétés de couplage et de localisation de la structure selon l'invention. Sur la figure, le profil h(x) est ainsi essentiellement binaire, le motif ME pouvant être décrit comme une série de deux créneaux, dont les paramètres a, b, c, d définissent les longueurs et espacements, et dont le paramètre $h_g$ définit la hauteur des créneaux, c'est à dire en pratique la profondeur de l'opération de gravure réalisée pour obtenir le motif élémentaire ME de la structure selon l'invention.

Ce profil binaire est le plus efficace, mais en pratique, on peut obtenir des profils un peu différents, avec notamment des incertitudes allant jusqu'à 20 pour cent de la valeur moyenne sur les hauteurs $h_t$ et $h_d$. Ainsi, le motif général de l'invention est à considérer en prenant les valeurs a, b, c et d à mi-hauteur, avec des portions $p_a$ et $p_c$ sensiblement de même hauteur et des portions $p_b$ et $p_d$ sensiblement de même hauteur.

On a ainsi 5 paramètres de définition du profil h(x) pour définir une structure optique selon l'invention. Ces paramètres sont simples à obtenir : une unique opération de gravure est nécessaire, et permettent d'adapter les propriétés de couplage et de localisation d'une structure optique selon l'invention.

Le profil h(x) peut en effet être décrit comme illustré sur la figure 3, par une fonction mathématique égale au premier ordre à la somme de l'harmonique d'ordre 1 noté f(x,y, $\Lambda$) d'amplitude $\alpha$ et de période $\Lambda$, et l'harmonique d'ordre 2 noté g(x,y, ½ $\Lambda$) d'amptitude $\beta$ et de période ½$\Lambda$ de la série de Fourier à amplitude complexe correspondante.

Le déphasage relatif $\delta\Lambda$ entre les deux harmoniques correspond à l'écartement entre deux maximas respectifs (figure 3).

Les paramètres a, b, c, d et $h_g$ sont notamment choisis de telle sorte que l'amplitude complexe de la première harmonique non nulle d'ordre supérieur à deux soit négligeable devant les amplitudes complexes $\alpha$ et $\beta$ des harmoniques d'ordre 1 et 2. En pratique, ils sont choisis pour minimiser l'ordre 3. Ils sont aussi choisis pour que le déphasage relatif $\delta\Lambda$ qui conditionne le couplage soit optimal.

Plus précisément, l'amplitude complexe $\alpha$ de l'harmonique f(x, y, A) d'ordre 1 s'écrit :

$$\alpha = h_g \left( \int_{a}^{a+b} \exp\left( i\frac{2\pi}{\Lambda}.x \right)dx + \int_{a+b+c}^{a+b+c+d} \exp\left( i\frac{2\pi}{\Lambda}.x \right)dx \right) \quad \text{Eq.1}$$

L'amplitude complexe $\beta$ de l'harmonique g(x, y, ½$\Lambda$) d'ordre 2 s'écrit :

$$\beta = \frac{1}{2}h_g \left( \int_{a}^{a+b} \exp\left( i\frac{4\pi}{\Lambda}.x \right)dx + \int_{a+b+c}^{a+b+c+d} \exp\left( i\frac{4\pi}{\Lambda}.x \right)dx \right) \quad \text{Eq.2}$$

Le déphasage relatif est une fonction de la phase entre $\beta$ et $\alpha$ : $\delta\Lambda=\Lambda/2\pi.\Phi(\beta/\alpha)$ (Eq.3), ($\Phi$ étant égale à la tangente inverse de la partie imaginaire de $\beta/\alpha$ sur la partie réelle de $\beta/\alpha$).

On peut exprimer quatre paramètres en fonction d'un cinquième. Par exemple, on peut exprimer b, c et d comme des variables fonction de a, sachant qu'en outre a, b, c et d vérifient a+b(a)+c(a)+d(a)= A . On choisit alors a de telle sorte que les ordres supérieurs soient minimisés, au moins le premier ordre non nul supérieur à deux.

Par exemple, pour minimiser l'ordre trois, on choisit a tel que

$$\frac{d}{da}\left| \int_{a}^{a+b(a)} \exp\left(i\frac{6\pi}{\Lambda}.x\right) + \int_{a+b(a)+c(a)}^{a+b(a)+c(a)+d(a)} \exp\left(i\frac{6\pi}{\Lambda}.x\right) \right| \text{ est minimum } \quad \text{(Eq.4)}.$$

Le profil h(x) du motif élémentaire ME selon l'invention peut ainsi être défini par une fonction mathématique, qui est la somme des deux fonctions périodiques g(x, y, ½Λ) et f(x, y, A), f représentant la fonction de couplage entre la lumière et le champ électromagnétique de l'onde excitée en surface, de période spatiale A et g représentant la fonction de localisation de période spatiale 2A. La phase relative δΛ entre f et g conditionne les propriétés finales de localisation de l'onde couplée. S'agissant par exemple d'un photodétecteur comprenant une structure optique selon l'invention, si on note λ la longueur d'onde moyenne du rayonnement incident, avantageusement, le pas A doit être égal à λ/n pour obtenir un couplage optimal entre l'onde lumineuse incidente sur le photodétecteur et le mode de surface utile. Ces propriétés dépendent des paramètres a, b, c, d et $h_g$.

Une structure périodique selon l'invention est basée sur la réplique du motif élémentaire ME que l'on vient de décrire, combinée à la réalisation d'un défaut dans la périodicité de la structure, de préférence dans une zone au centre de la structure.

Plus précisément une structure optique selon l'invention comprend ainsi, comme illustrée de façon schématique sur la figure 2, une première zone de relief A et une deuxième zone de relief B, chacune obtenue par la répétition périodique du motif élémentaire ME, de période A. Ces deux zones A et B sont symétriques l'une de l'autre par rapport à un plan de symétrie Π parallèle à Oyz. Sur la figure 2 qui est une figure en coupe 0xy, c'est l'axe de symétrie parallèle à 0y de ce plan Π qui est visible.

Les deux zones A et B sont séparées par une troisième zone C disposée au centre de la structure.

La zone C crée un défaut de périodicité du profil y=h(x,z) de la structure optique. Le défaut de périodicité de la structure est ce qui conduit à l'effet de localisation en x et y du champ électromagnétique sous la couche de perméabilité diélectrique négative, au niveau de la zone C.

Cette zone C peut avoir un profil quelconque dans le plan 0xy, et est invariante selon 0z. Elle peut en pratique être obtenue de différentes façons.

Dans l'invention, on propose deux réalisations avantageuses d'une structure optique selon l'invention.

Une première réalisation est équivalente à intercaler entre les deux zones symétriques A et B, une zone C ayant une longueur égale à un nombre m entier supérieur ou égal à 1 de périodes A. Les zones A et B sont distantes l'une de l'autre, de la longueur de la zone C. Cette zone C peut avoir un profil quelconque. Pour faciliter la réalisation, elle est sensiblement de même hauteur sur toute cette longueur.

Une deuxième réalisation est équivalente à créer une symétrie par rapport à une droite parallèle à Oy et passant en un point particulier du motif. La zone C est alors de longueur nulle. Les deux zones A et B se joignent sur l'axe de symétrie Π. Ces deux réalisations avantageuses sont détaillées infra.

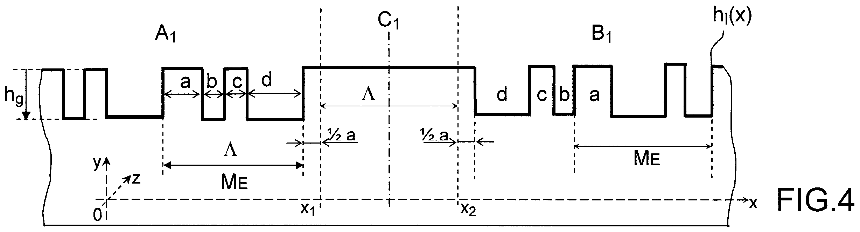

Le premier mode de réalisation préféré d'une structure optique selon l'invention est illustré en coupe 0xy sur la figure 4. La structure optique est définie par un profil $h_l(x)$. Ce profil $h_l(x)$ comprend une première zone $A_1$ de répétition périodique du motif élémentaire ME et une deuxième zone $B_1$ symétrique de la zone $A_1$ par rapport à l'axe de symétrie Π. Les deux suites $A_1$ et $B_1$ sont de même période A. Elles sont séparées par une zone $C_1$, de largeur l égale à un nombre m entier non nul de périodes A. Dans l'exemple illustré sur la figure 4, m vaut 1. Les suites $A_1$ et $B_1$ comprennent avantageusement le même nombre entier N/2 de motifs élémentaires. La zone $C_1$ se trouve dans la région centrale de la structure. L'axe de symétrie Π parallèle à 0y passe par le milieu de la structure suivant 0x.

La zone $C_1$ peut avoir un profil quelconque dans le plan 0xy, et invariant suivant 0z. Dans l'exemple illustré, cette zone $C_1$ a une hauteur sensiblement égale à la hauteur $h_t$ des première et troisième portions du profil $h_l(x)$, c'est à dire que dans cette zone $C_1$, on n'a pas fait de gravure. On pourrait à l'inverse avoir gravé cette zone $C_1$ sur toute sa longueur, en sorte que cette zone aurait une hauteur sensiblement égale à la hauteur $h_d$ des deuxième et quatrième portions du profil $h_l(x)$. Plus généralement cette zone est sensiblement de même hauteur sur toute sa longueur l (c'est à dire qu'elle a un relief sensiblement plan suivant 0xz), ce qui est simple à réaliser.

La zone $C_1$ est telle qu'elle débute en un point de position $x_1$ sur l'axe 0x correspondant sensiblement au milieu d'une première portion $p_a$ d'un motif élémentaire ME de ladite première zone $A_1$ et se termine en un point de position $x_2$ sur l'axe 0x correspondant sensiblement au milieu d'une première portion d'un motif élémentaire de deuxième zone $B_1$.

Le processus de construction d'un tel profil $h_l(x)$ comme illustré schématiquement avec m=1 sur la figure 4, revient à enlever m périodes A dans une suite périodique de motif ME, entre deux points milieu $x_1$ et $x_2$ d'une portion $p_a$, et à remplacer cette partie par un motif quelconque, de préférence une zone sans motif, comme illustré.

Le déphasage relatif δΛ entre les harmoniques f(x,y,Λ) et g(x, y,½Λ) est alors sensiblement nul.

La zone $C_1$ crée un défaut dans la périodicité de la structure. Il en découle une localisation des ondes de surface suivant 0x et 0y sous cette zone.

La structure optique ainsi définie avec un profil $h_l(x)$ permet d'optimiser la localisation en 0x et en 0y du champ, en fonction de $h_g$, a, b, c et d vérifiant les équations Eq.1 à Eq.4.

Une structure optique telle qu'illustrée sur la figure 4 est particulièrement bien adaptée à des applications dans lesquelles on cherche à privilégier de forts facteurs de qualité d'onde de surface.

Elle est plus particulièrement destinée à des applications en bandes étroites, où la variance de fréquence $\Delta\nu$ est très inférieure à 0.1 v.

De préférence, on choisit en outre les relations suivantes :

$$a \neq c \text{ et}$$
$$b = d,$$

ce qui impose un déphasage relatif $\delta\Lambda$ nul.

Cette contrainte supplémentaire réduit le nombre de solutions à l'équation Eq.4 précédente, mais permet de simplifier le dessin de la structure optique selon l'invention.

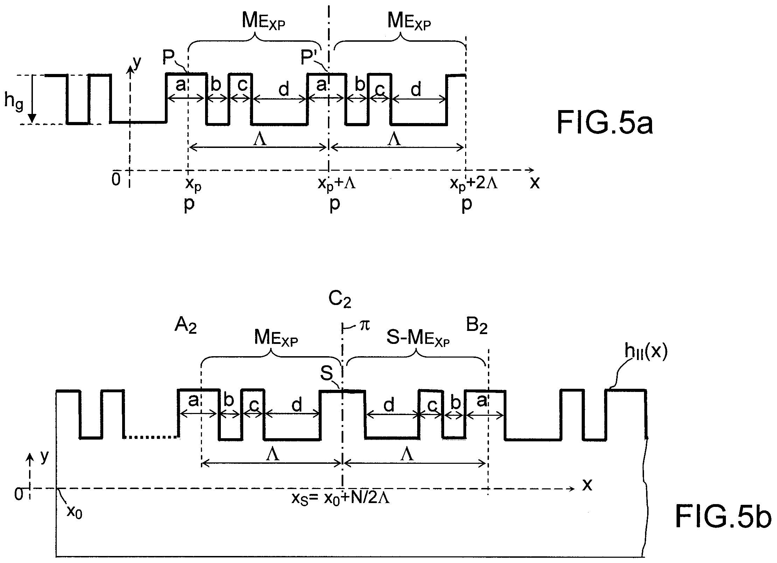

Le deuxième mode de réalisation préféré est illustré sur les figures 5a et 5b. Il est particularisé par un profil $h_{II}(x)$ de la surface en relief de cette structure. Ce profil $h_{II}(x)$ comprend une première zone $A_2$ et une deuxième zone $B_2$. La zone $A_2$ est obtenue par répétition périodique, à la période A d'un motif particulier $ME_{XP}$, obtenu du motif élémentaire ME par translation sur l'axe Ox. La zone $B_2$ est symétrique de la zone $A_2$ par rapport à l'axe de symétrie $\Pi$. Dans l'exemple, les zones $A_2$ et $B_2$ comportent chacune le même nombre N/2 de motifs. La première zone $A_2$ comprend ainsi un nombre N/2 fois la réplique du motif $ME_{XP}$. Ce motif est défini entre un point P de d'abscisse $x_p$ (sur l'axe 0x) et un point P' d'abscisse $x_p+\Lambda$ d'une suite périodique du motif ME, comme illustré sur la figure 5a.

Le point P de position $x_p$ est choisi tel que l'équation suivante soit vérifiée :

$$\int_{x_p}^{x_p+\Lambda} h(x).\sin\left(\frac{2\pi.x}{\Lambda}\right).dx = 0 \qquad \text{Eq.5}$$

On notera qu'il y a deux solutions à une telle équation. Cette équation permet de garantir un couplage optimal entre le champ électromagnétique et l'onde lumineuse, qui rappelons-le, dépend de la phase relative entre les deux harmoniques d'ordre 1 et 2.

Comme illustré sur la figure 5b, la deuxième zone $B_2$ est obtenue par une opération de symétrie par rapport au plan de symétrie dont seul l'axe de symétrie $\Pi$ est visible sur la figure. Ce plan coupe l'axe 0x en un point S d'abscisse $x_0+N/2.\Lambda$, en notant $x_0$ l'abscisse sur l'axe 0x du point correspondant au début de la zone $A_2$. Ce point S correspond au centre de la structure sur l'axe 0x.

La zone $C_2$ de la structure optique selon l'invention est une zone de longueur nulle qui dans le plan 0xyz, correspond ou se confond avec le plan de symétrie $\Pi$.

Pour des paramètres a, b, c, d, $h_g$ choisis en utilisant Eq.1 à Eq.4, et $x_p$ choisi pour que l'équation Eq.5 soit vérifiée, le déphasage relatif $\delta\Lambda$ entre le premier harmonique $f(x,y,\Lambda)$ et le deuxième harmonique $g(x,y,\frac{1}{2}\Lambda)$ de la série de Fourier correspondante, est sensiblement égal à A/4.

Une structure optique ayant un tel profil $h_{II}(x)$ privilégie une forte localisation sur l'axe 0x, dans une zone centrale de la structure optique, qui est délimitée autour de la zone $C_2$.

Une telle structure optique est plus particulièrement adaptée à des applications à bande non étroite, typiquement avec une variance $\Delta\nu$ de la fréquence de l'ordre de 0.1v, ou dans le cas où l'absorption dans le métal prévient l'exploitation des effets résonnants.

Une structure optique selon l'invention, selon l'un ou l'autre profil décrit en relation avec les figures 4 et 5b est simple de réalisation. Le procédé de fabrication de cette structure consiste principalement, après avoir défini les paramètres a, b, c, d et $h_g$ comme décrit, à dessiner le masque de gravure correspondant, à graver une couche d'un matériau, qui peut être quelconque, selon le dispositif pour lequel on réalise la structure optique, à déposer une fine couche d'un métal par dessus pour former la surface en relief $1_b$ de la structure optique 1 comme illustré sur la figure 1. La fine couche de métal est matérialisée sur la figure 1 par le trait en gras. La surface en relief peut encore être réalisée directement dans une couche de semi-conducteur dopée, en sorte que sa perméabilité diélectrique soit négative, par gravure. La surface en relief est d'un côté en contact avec le milieu de perméabilité diélectrique positive, qui peut être le vide ou un matériau de type semi-conducteur.

Si le milieu de perméabilité diélectrique positive est le vide, la structure optique sera généralement supportée par un substrat quelconque.

Si le milieu de perméabilité diélectrique positive est un matériau semi-conducteur, la structure optique pourra être protégée par une couche de protection, par exemple une couche de diélectrique, ou pourra être exposée à l'air libre.

S'agissant de la perméabilité diélectrique, on fera la remarque suivante : dans tous les conducteurs, la perméabilité diélectrique change de signe : elle est négative à basse fréquence et positive à haute fréquence. La fréquence de transition, appelée dans la littérature fréquence de plasma, dépend de la conductibilité. Les métaux ont ainsi leur fréquence de plasma dans l'ultraviolet. La fréquence de plasma des matériaux semi-conducteurs dépend du dopage. Elle est généralement située dans le domaine du lointain infrarouge (longueur d'onde supérieure à 30 microns). Si les matériaux semi-conducteurs sont très dopés, on peut se rapprocher de la fréquence de plasma des métaux. C'est ainsi que la surface en relief de la structure optique selon l'invention peut être réalisée dans un métal ou dans un matériau semi-conducteur très fortement dopé.

Enfin, comme il ressort de ce qui précède, la perméabilité diélectrique négative ou positive à laquelle on se réfère dans l'invention, est regardée par rapport au domaine spectral opérationnel du dispositif intégrant la structure, c'est à dire la longueur d'onde du rayonnement optique incident que l'on cherche à détecter ou la longueur d'onde du rayonnement optique émis par le dispositif.

Nous allons maintenant décrire différentes applications d'une structure optique selon l'invention, selon l'une ou l'autre des mises en oeuvre décrites précédemment. Dans ces applications, la structure optique est définie par ses zones A, B et C telles que décrites supra.

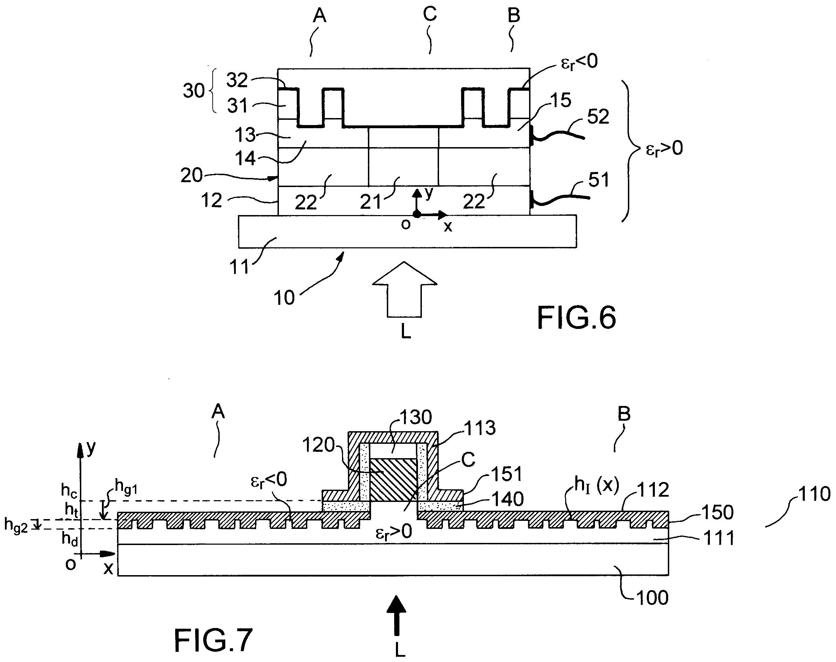

La figure 6 illustre un photo-détecteur 10, comprenant une structure optique 30 selon l'invention. Dans l'exemple, cette structure à une surface en relief ayant un profil de type $h_I(x)$.

Dans ce dispositif 10, le milieu de perméabilité diélectrique positive est un matériau de type semi-conducteur. Il fournit un signal électrique correspondant à la détection d'une onde électromagnétique, au moyen d'un élément optique actif 21 de photodétection. Des photodétecteurs du type à puits quantiques sont notamment utilisés pour détecter un rayonnement infrarouge dans des longueurs d'onde typiquement comprises entre 1 et quelques centaines de micromètres.

Le photo-détecteur 10 comprend essentiellement, selon l'illustration en coupe transversale dans le plan 0xy :

- une structure optique 30 selon l'invention,
- un substrat semi-conducteur 11 support du photo-détecteur, transparent au rayonnement optique L que l'on cherche à détecter;
- un élément optique actif, qui est une zone de photodétection 21 réalisée dans une couche semi-conductrice 20, disposée centrée par rapport à la zone C de la structure optique, et qui fournit un signal électrique correspondant à la détection d'une onde électromagnétique d'une longueur d'onde déterminée,
- la période A de la structure optique 30, multipliée par l'indice de réfraction de la couche 20 comportant l'élément optique actif est choisie proche de la longueur d'onde.

La structure optique 30 comprend une couche 31 qui est gravée et recouverte d'une pellicule de métal 32, figurée par un trait gras, qui offre la surface en relief recherchée par exemple de type $h_I(x)$ ou $h_{II}(x)$. Sur l'illustration de la figure 6, il s'agit du profil $h_I(x)$. La gravure de la couche 31 est telle que la couche de métal 32 vient au contact de la couche conductrice 13. A titre d'exemple non limitatif, la couche 31 est une couche d'un matériau diélectrique et le métal 32 est de l'or ou du palladium. L'épaisseur de la couche de métal est de quelques dizaines de nanomètres, supérieure à la profondeur de peau dudit métal dans le domaine spectral de fonctionnement considéré, afin d'empêcher la transmission du rayonnement L. La structure optique 30 peut comprendre en outre une couche de matériau diélectrique 33, qui recouvre la couche 32, en sorte d'assurer la protection de la structure.

Le choix du profil $h_I(x)$ ou $h_{II}(x)$ dépend des propriétés recherchées pour la photodétection, notamment, mais pas seulement, si la bande spectrale opérationnelle doit être de type bande étroite ($h_I(x)$) ou large bande ($h_{II}(x)$).

On notera que dans un tel dispositif de détection muni d'une structure optique de l'invention, l'amplitude $\alpha$ du premier harmonique définit le couplage et l'amplitude $\beta$ et le déphasage relatif $\delta\Lambda$, la localisation suivant 0x et 0y.

Dans une variante non représentée, la structure optique 30 est réalisée dans une couche de semi-conducteur fortement dopée, en sorte d'offrir une perméabilité diélectrique négative dans le domaine spectral opérationnel du photodétecteur, et dont la face supérieure présente le relief selon l'invention, avec par exemple un profil de type $h_I(x)$ ou $h_{II}(x)$.

La zone de photodétection 21 est entourée d'une zone périphérique 22 inactive à la longueur d'onde considérée. Elle a des dimensions en x et z choisies pour correspondre essentiellement à la localisation du champ électromagnétique en x. Dans le cas d'une structure de type $h_I(x)$, les dimensions en x de la zone de photodétection 21 correspondent sensiblement à la longueur de la zone C.

La zone de photodétection est située à proximité de la surface en relief de la structure optique, pour optimiser la détection. En effet, l'amplitude du champ électromagnétique décroît depuis la surface en relief vers le substrat.

Des zones de contacts électriques 51 et 52 sont prévues en pratique qui permettent de capter le signal électrique issu de la zone active. A cet effet, on prévoit par exemple comme illustré, une couche semi-conductrice dopée 13, entre la couche semi-conductrice 20 et la structure optique 30 et une couche semi-conductrice dopée 12 entre la couche semi-conductrice 20 et le substrat 11. Les contacts électriques 51 et 52 sont alors pris sur ces couches conductrices 12 et 13 qui sont des couches semi-conductrices dopées encadrant la zone active.

Les couches ou zones 11, 12, 22, 13 et 31 sont choisies transparentes dans le domaine spectral de fonctionnement du photodétecteur ; elles offrent toutes une perméabilité diélectrique positive $\varepsilon_r$ pour le domaine spectral dans lequel s'opère la photodétection, typiquement le domaine infrarouge. Les différentes couches de semi-conducteur 11, 12, 20, 13 du dispositif sont par exemple, de manière connue, des matériaux de la famille III-V.

Le fonctionnement du photo-détecteur comprenant une structure optique selon l'invention est le suivant. Le faisceau de lumière L à détecter éclaire le photo-détecteur par le substrat 11, sous une incidence voisine de la normale. Ce faisceau passe à travers le substrat 11, la couche conductrice 12 et la couche semi-conductrice 20 comprenant la zone active de photodétection 21, sans atténuations sensibles. Il atteint la structure optique 30, provoquant l'excitation d'une onde de surface en polarisation transverse magnétique, c'est-à-dire dont le champ électrique est perpendiculaire au réseau. La structure optique a aussi pour effet de localiser le faisceau lumineux qu'il capture, dans une zone centrale correspondant à la zone de photodétection 21. On améliore ainsi le rapport signal à bruit, ce qui est le but recherché.

Une structure optique selon l'invention permet d'avoir une zone de photodétection de petites dimensions, correspondant en pratique à une petite région au-dessous de la zone C. Le faisceau lumineux capturé par le dispositif est localisé dans cette zone de photodétection. Le rapport signal sur bruit du dispositif est amélioré.

Dans un photodétecteur du type à puits quantiques, la limitation des dimensions de la zone de photodétection 21 à puits quantiques, peut impliquer :

- la neutralisation des puits quantiques dans la zone périphérique 22, par implantation de protons par exemple ;
- la limitation du courant dans une zone 14, 15 de la couche conductrice 13 correspondant à la zone périphérique 22, par neutralisation du dopage dans ces zones 14, 15, par exemple par implantation de protons.

Une variante d'un dispositif de photodétection selon l'invention est représentée sur la figure 7. Dans cette variante, on dispose l'élément optique actif au-dessus de la zone C et non plus en dessous, afin de bénéficier de conditions de détection optimales. En effet, en plaçant l'élément optique actif au-dessus de la zone C, cet élément voit une amplitude constante du champ électrique, correspondant à l'amplitude maximale.

La mise en oeuvre de cette variante nécessite une structure optique dont la zone C de la surface en relief est de longueur non nulle, c'est à dire avec un profil de type $h_l(x)$.

Un photodétecteur correspondant (Figure 7) comprend une structure optique 110 comprenant une couche de semi-conducteur dopée 111 de perméabilité diélectrique positive, et une première couche 112 et une deuxième couche 113 de matériau de perméabilité diélectrique négative.

La couche 111 est gravée en sorte de présenter une surface en relief inverse du profil $h_l(x)$ (Figure 4).

La première couche 112 de matériau de perméabilité diélectrique négative recouvre la surface en relief de la couche 111, en sorte que la zone C est formée par un trou dans cette couche. L'élément optique actif 120 est disposé directement au contact de la couche 111, cette couche 111 se trouvant à un niveau $h_c$ au-dessus de la première couche 112 dans la troisième zone C, avec une hauteur $h_c$ supérieure à celles des portions $p_a$ et $p_b$ du profil selon l'invention.

La deuxième couche 113 de matériau de perméabilité diélectrique négative est disposée au-dessus de l'élément optique actif, et isolée électriquement de la première couche 112.

Les première et deuxième couches 112 et 113 fournissent respectivement un premier contact électrique 150 et un deuxième contact électrique 151 pour délivrer le signal électrique de photodétection.

L'élément optique actif 120 est une zone de photodétection disposée sur la couche 111, sur la zone C. Elle est donc située à une hauteur $h_c$ au-dessus des portions hautes $p_a$, $p_c$ du profil $h_l(x)$ (figures 1, 4)). De cette façon, il est possible de réaliser les contacts électriques par lesquels on récupère le signal de photodétection, sans risquer de mettre en contact une couche de métal directement avec la zone de photodétection 120.

En pratique, la structure optique correspondante nécessite alors deux opérations successives de gravure, une première gravure sur une profondeur $h_{g1}=h_c-h_t$, sur toute la surface de la couche de semi-conducteur dopée, exceptée dans la zone C. Puis on effectue une deuxième gravure sur une profondeur $h_{g2}=h_t-h_d$, selon le dessin du motif élémentaire $M_E$.

Plus précisément, dans l'exemple de réalisation illustré sur la figure 7, le dispositif comprend un substrat 100, la structure optique 110 comprenant la couche semi-conductrice dopée 111, et les couches 112 et 113, une zone de photodétection 120, de dimensions limitées dans le plan de surface Oxz aux dimensions de la zone C, disposée par dessus au contact de la couche 111 dans la zone C et centrée sur cette zone C. Les couches 112 et 113 sont des couches de métal, par exemple de l'or.

La couche 111 formant une couche de contact de la zone de photodétection 120, la couche de métal 112 forme un contact électrique 150 correspondant.

Une couche de semi-conducteur dopé 130 est prévue sur la zone de photodétection 120, pour former une deuxième couche de contact de cette zone 120. Cette couche 130 est recouverte de la couche de métal 113, qui fournit un autre contact électrique 151. Le signal de photodétection du dispositif est obtenu aux bornes des deux contacts électriques 150 et 151.

En pratique, une couche diélectrique 140 est prévue pour isoler latéralement la zone de photodétection 120 de la couche de métal 113 et isoler les contacts 150 et 151.

Un tel dispositif présente des qualités de photodétection d'un éclairement L très intéressantes, du fait du positionnement de la zone de photodétection 120 au-dessus de la zone de localisation en x et y du champ. En effet, le champ électrique de surface sous une structure optique selon l'invention est décroissant depuis la surface en relief du matériau de perméabilité diélectrique négative vers le matériau de perméabilité diélectrique positive, en dessous. Depuis la surface en relief du matériau de perméabilité diélectrique négative et au-dessus, le champ électrique de surface a une valeur constante. Notamment dans la zone de photodétection 120 de la structure, les valeurs du champ sont maximales, par l'effet de concentration de champ dans la zone C. On a ainsi un plus fort recouvrement du champ avec la zone de photodétection. Les performances de détection sont améliorées. Ceci est cependant obtenu au prix d'une réalisation un peu plus complexe, notamment avec plus d'étapes de gravure. Par contre, il n'y plus les étapes d'implantation de protons nécessaires pour la réalisation d'un dispositif comme illustré sur la figure 6, pour délimiter la zone de photodétection.

Les structures optiques utilisées dans les dispositifs qui viennent d'être décrits en relation avec les figures 6 et 7 ont comme avantage supplémentaire que leur réalisation utilise une simple étape de gravure du profil $h_I(x)$ ou $h_{II}(x)$, suivant des étapes technologiques comparables à celles utilisées pour réaliser les puits quantiques. Ainsi une structure optique selon l'invention s'applique avantageusement aux photodétecteurs de type QWIPs (Quantum Well Infrared Photodetector).

L'invention s'applique également à d'autres types de photodétecteurs, comme par exemple les détecteurs ou photoconducteurs inter-bande basés sur les familles de matériaux contenant de l'Antimoniure de Gallium (GaSb) ou du Mercure Cadmium Tellure (HgCdTe).

Les structures optiques selon l'invention peuvent être utilisées dans des photodétecteurs dont le domaine spectral de détection est autre que le moyen infra-rouge. Notamment, elle peut être utilisée dans le domaine des micro-ondes (fréquences de l'ordre du gigahertz), ou le domaine de l'infrarouge lointain (fréquences de l'ordre du térahertz) ou encore le domaine du proche infrarouge.

L'invention s'applique également aux matrices photosensibles comprenant une pluralité de photodétecteurs comportant chacun une structure optique selon l'invention, ces photodétecteurs étant disposés en lignes et en colonnes sur un support commun, selon les principes de réalisation de matrices photosensibles bien connus de l'homme de l'art.

Une autre application d'une structure optique sur un dispositif semi-conducteur selon l'invention concerne les émetteurs.

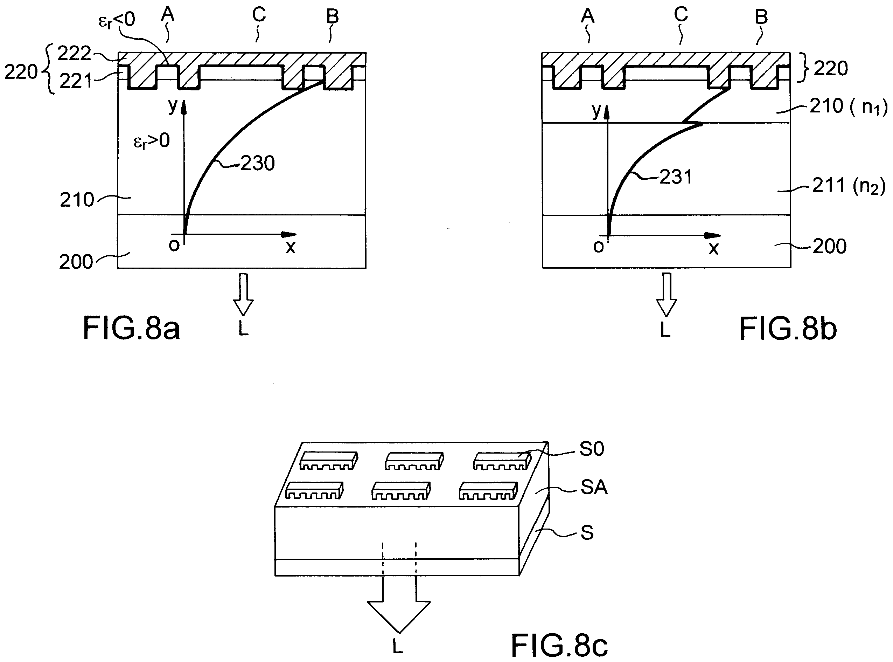

Un premier exemple de dispositif muni d'une structure optique selon l'invention, pour émettre un faisceau lumineux dans une bande spectrale opérationnelle donnée, par exemple le moyen infra-rouge, est illustré sur la figure 8a. Il s'agit plus particulièrement d'un dispositif de type émetteur à cascade quantique.

Un émetteur à cascade quantique de l'état de l'art comprend des couches semi-conductrices, principalement un substrat et une couche active, et une couche de métal sur la couche active. La couche active forme un guide d'onde, duquel est extrait, par la tranche, l'onde lumineuse générée sous l'effet de l'excitation électrique appliquée par la couche de métal. Une particularité d'un tel émetteur est la suivante : la couche active émet en polarisation perpendiculaire par rapport au plan des couches semi-conductrices. Pour cette raison, l'extraction du faisceau lumineux est difficile.

Dans l'invention, on combine la structure semi-conductrice d'un tel émetteur à une structure optique selon l'invention. C'est à dire que l'on remplace la couche de métal par une structure optique selon l'invention, comprenant une couche de métal présentant une surface en relief selon l'invention en contact avec la structure semi-conductrice qui forme le milieu de perméabilité diélectrique $\varepsilon_r$ positive.

Le mode laser émis par un émetteur quantique selon l'état de l'art est en effet un mode TM. Ce mode est compatible avec les plasmons de surface. Il est donc possible d'utiliser une structure optique selon l'invention avec un tel émetteur.

L'effet de cette combinaison est notamment d'améliorer la localisation du champ optique et de permettre une extraction verticale du faisceau laser, par la surface du substrat, ce qui résout les problèmes liés à l'extraction.

Une mise en oeuvre d'un tel émetteur à cascade quantique est illustrée sur la figure 8a. Le dispositif comprend un substrat 200, une zone active d'émission 210 et une structure optique 220 selon l'invention. La période A de la structure optique est choisie en sorte que sa valeur multipliée par l'indice optique de réfraction de la couche 210 formant la zone active est proche de la longueur d'onde du faisceau émis.

La zone active d'émission 210 est une couche permettant un gain optique. Par exemple, c'est une structure active de laser à cascade quantique, telle que par exemple décrite dans le brevet EP 1466393.

La structure optique 220 comprend au moins une première couche 221 semi-conductrice dopée transparente à la longueur d'onde d'émission et une deuxième couche métallique 222 non transparente à la longueur d'onde d'émission. La première couche présente une surface en relief suivant un profil h(x) selon l'invention, profil qui peut être du type $h_I(x)$ ou $h_{II}(x)$. La deuxième couche 221 recouvre cette surface en relief. La couche 221 est gravée en sorte que la couche 222 viennent en contact avec la zone active d'émission 210, voire pénètre la zone active comme illustré sur la figure 8a. On obtient ainsi une couche d'un matériau de perméabilité diélectrique négative, la couche 222, présentant une surface en relief selon l'invention en contact avec le milieu de perméabilité diélectrique positive qui est la structure semi-conductrice et qui comprend la zone active d'émission 210.

Les matériaux semi-conducteurs utilisés dans le dispositif sont typiquement des matériaux de la famille III-V.

Le profil de la surface en relief est plus particulièrement défini par ses paramètres a, b, c, d, $h_g$ pour que l'amplitude $\alpha$ du premier harmonique f(x,y, A) soit très inférieure à l'amplitude $\beta$ du deuxième harmonique g(x, y, ½Λ), de manière à privilégier la localisation. Le couplage ne doit pas être en effet trop élevé sous peine de tuer l'effet laser. Plus généralement ces amplitudes sont choisies pour obtenir l'effet laser.

Le paramètre $h_g$ est plus particulièrement choisi en fonction de la longueur du dispositif considéré et du gain disponible. Elle est optimisée en recourant de manière bien connue à une modélisation électromagnétique précise.

Le principe de fonctionnement est ainsi la détection du champ et l'émission verticale d'un rayonnement lumineux L comme illustré sur la figure 8a. L'évolution du mode optique dans le dispositif est représenté sous la référence 230 sur la figure 8a.

Si on prend l'exemple d'un laser, on obtient avec une seule étape technologique supplémentaire par rapport à l'art antérieur;

- une localisation verticale, selon 0y, du mode électromagnétique ;
- une cavité laser suivant le plan 0xz des couches, sans besoin de clivage (puisqu'il n'y a plus d'extraction par la tranche, mais extraction verticale), dans une région délimitée sous la zone C (ou autour de la zone C quand celle-ci est de longueur nulle, cas du profil $h_{ll}(x)$), où le champ optique est le plus intense;
- une très bonne extraction du rayonnement, avec un faisceau laser collimaté et peu divergent L en direction verticale (émission par la surface inférieure du substrat).

La structure optique selon l'invention peut aussi être utilisée dans le cas d'un dispositif utilisant une ou plusieurs couches fortement dopées (*Plasmon enhanced*) comme illustré sur la figure 8b. Au moins une couche supplémentaire 211 est alors prévue entre le substrat 200 et la couche active 210. Cette couche 211 est fortement dopée, plus fortement dopée que la couche active 210 de façon à obtenir avec cette dernière un fort contraste d'indice de réfraction, nécessaire à la localisation du champ optique. Cette couche 211 a ainsi un indice optique $n_2$ plus faible que l'indice optique $n_1$ de la couche active 210. Une telle hétéro-structure 210, 211 est utilisée dans l'état de l'art pour réduire les pertes par absorption dans la couche de métal. Sous la référence 231 sur la figure 8b est représentée l'évolution du mode optique dans les couches 210 et 211.

Notamment on utilise un tel dispositif pour réaliser des lasers à cascade quantique fonctionnant en infrarouge moyen. La localisation est améliorée.

La mise en oeuvre technologique de l'invention étant simple, on peut l'appliquer à la réalisation d'une pluralité d'émetteurs sur un même support, dans le but de réaliser un réseau, comme schématiquement illustré sur la figure 8c. On a ainsi un substrat S et une structure active SA comprenant une couche active et éventuellement d'autres couches semi-conductrices (hétéro-structure), et sur cette structure active, une pluralité de structures optiques SO selon l'invention, disposées matriciellement en lignes et colonnes, formant autant d'émetteurs élémentaires que de structures optiques. Ces émetteurs ont comme avantage de pouvoir être synchronisés, et commandés notamment pour contrôler la direction de chaque faisceau laser élémentaire émis, dans le but de fournir en sortie un unique faisceau laser L (balayage électronique de faisceau).

L'invention n'est pas limitée à une émission dans le domaine spectral infrarouge, mais s'applique à un domaine spectral plus vaste, selon les matériaux utilisés notamment, et la structure du dispositif.

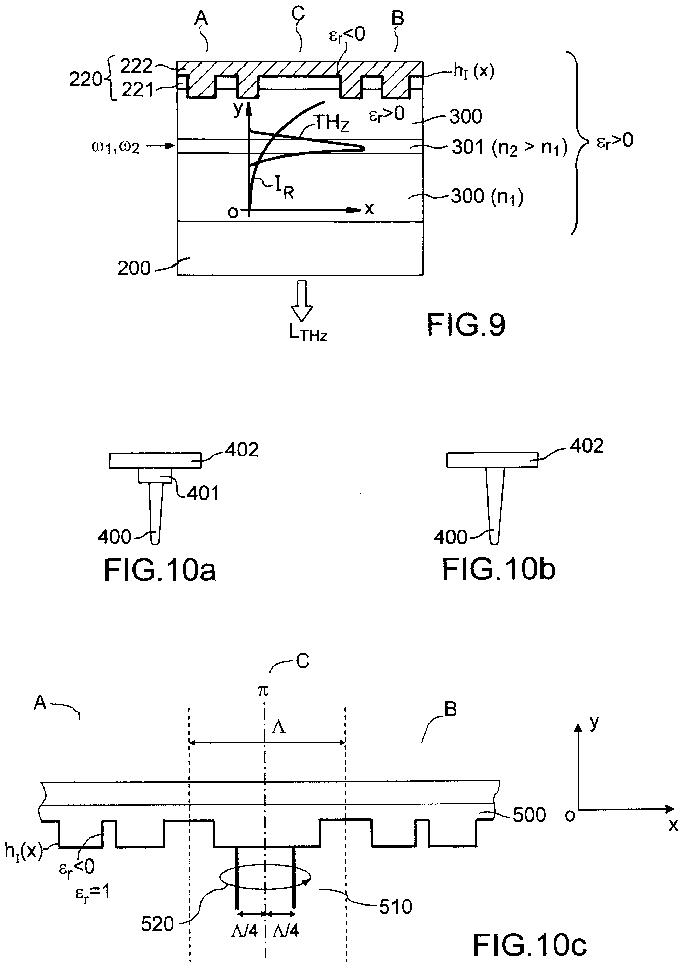

Notamment, elle s'applique aussi bien dans le domaine de la génération d'ondes terahertz ( c'est à dire à une longueur d'onde comprise entre 70 et 300 micromètres), comme illustré sur la figure 9, et ce de façon très avantageuse par rapport à l'état de l'art.

Selon l'état de l'art, la génération d'ondes terahertz peut être obtenue par conversion de fréquence optique, au moyen d'un milieu non linéaire d'ordre 2, comprenant une couche optique non linéaire, dans laquelle on réalise un guide d'onde non linéaire, avec un matériau d'indice optique plus élevé. Ce guide d'onde est éclairé à une extrémité, par la tranche du dispositif, par deux sources lasers fournissant deux fréquences optiques $\omega_1$ et $\omega_2$. L'interaction non linéaire de ces deux fréquences optiques provoque l'émission d'une onde terahertz à la fréquence différence. Le guide d'onde doit être un milieu transparent dans le proche infrarouge et le domaine terahertz. Dans un exemple, on utilise par exemple, des semi-conducteurs de la famille III-V tel que du GaAs en croissance [1 0 0], les deux fréquences optiques du domaine proche infrarouge étant polarisées suivant 0x et l'onde terahertz étant polarisée suivant 0y (mode TM).

En pratique la structure du dispositif doit permettre la réalisation de l'accord de phase entre le mode Terahertz guidé, et les fréquences optiques. La fréquence d'accord de phase ne dépend que des propriétés intrinsèques du matériau non linéaire. Par exemple, avec du GaAs l'accord de phase n'est possible qu'avec des fréquences optiques bien définies autour de 1.2 micromètres. Pour ces raisons, on est limité dans le choix des sources laser.

La localisation du champ dépend principalement du contraste d'indice, et des possibilités de croissance des matériaux.

On est en pratique limité par les possibilités de contrastes d'indice offertes par les semi-conducteurs, et en particulier les limitations technologiques de croissance des matériaux semi-conducteurs, ce qui pose des problèmes de localisation de l'onde générée.

L'utilisation de couches dopées et deux couches métalliques de part et d'autres du guide d'onde, permettent d'améliorer cet aspect. Une structure de génération d'onde terahertz par contraste d'indice selon l'état de l'art comprend ainsi une membrane semi-conductrice revêtue de métal sur ses deux faces. Une telle structure est particulièrement délicate à réaliser, et pose un problème d'extraction de la lumière : en effet les deux faces métalliques ont pour effet d'entraîner une désadaptation d'impédance entre le champ de la couche active, et l'espace libre, et donc des problèmes de réflexion de l'onde terahertz. Ce problème de désadaptation entre le guide d'onde et l'espace libre rend l'extraction plus difficile.

En utilisant une structure optique selon l'invention, on peut satisfaire la condition d'accord de phase de manière plus indépendante des propriétés des matériaux, en exploitant la dispersion induite par la périodicité. De plus on résout les différents problèmes de confinement et d'extraction : la localisation du champ près de la surface métallique de la structure optique répond au problème de confinement de la lumière : le confinement n'est plus réalisé par le contraste d'indice mais par la géométrie de la structure optique, le degré de confinement étant contrôlé par l'amplitude du deuxième harmonique correspondant au profil de la structure. Et on n'a plus besoin d'une deuxième couche métallique. Enfin, l'onde terahertz est émise par la surface.

Dans l'invention, on applique une structure optique selon l'invention à un tel émetteur (figure 9), avec une période A telle que sa valeur multipliée par l'indice de réfraction moyen des couches de l'émetteur est sensiblement proche de la longueur d'onde terahertz que l'on souhaite générer.

On a alors un dispositif dont le milieu de perméabilité diélectrique positive est la structure semi-conductrice de l'émetteur.

Cette structure comprend principalement un élément optique actif, formé par une couche de matériau non linéaire 300, transparent à des longueurs d'onde du domaine proche infra-rouge et terahertz. Cette couche comprend un guide d'onde semi-conducteur non linéaire 301 également transparent à des longueurs d'onde du domaine proche infra-rouge et terahertz.

Les matériaux semi-conducteurs non linéaires sont typiquement choisis dans la famille III-V tel que du GaAs, ou AlGaAs par exemple. Pour le guide d'onde 301, un des axes cristallographiques [110] ou [-110] est orienté selon 0x.

Le guide d'onde est formé par une couche de matériau dont la perméabilité diélectrique positive est supérieure à celle de la couche active 300.

La structure optique est disposée sur la couche 300. La structure optique est dans l'exemple identique à celle vue aux figures 8a et 8b. La couche métallique 222 vient en contact de la couche 300, voire pénètre la couche 300 comme illustré. Le profil de la surface en relief est plus particulièrement défini par ses paramètres a, b, c, d, $h_g$ pour que l'amplitude $\alpha$ du premier harmonique f(x,y, A) soit très inférieure à l'amplitude $\beta$ du deuxième harmonique g(x, y, ½Λ), de manière à privilégier la localisation.

Le dispositif ainsi constitué permet une émission verticale d'une onde terahertz $L_{THZ}$ générée par conversion de fréquence optique, en réponse à un éclairement du guide d'onde suivant l'axe 0x sous deux fréquences optiques $\omega_1$ et $\omega_2$ différentes du domaine proche infrarouge.

Les performances du dispositif sont améliorées. Notamment, la structure optique permet d'obtenir :

- une localisation du champ terahertz généré en polarisation TM, sans avoir recours à des couches dopées ni à deux couches métalliques; la réalisation du dispositif est alors beaucoup plus simple;
- une cavité résonnante pour ce champ, car sa taille est finie, typiquement de l'ordre de 1 millimètre à quelques millimètres suivant 0x, correspondant au confinement du champ électromagnétique dans un volume délimité suivant 0z, par la largeur de la structure, suivant 0x, par la longueur de la structure, et suivant 0y, du fait de l'existence d'une onde de surface.
- une modification de la dispersion dans le domaine terahertz, ce qui permet de régler l'accord de phase. C'est ce qui permet de choisir les sources laser qui conviennent le mieux à l'application, alors que dans l'état de l'art, le choix est limité à la condition d'accord de phase. La marge de manoeuvre est ainsi plus aisée par l'utilisation d'une structure optique selon l'invention.

Dans un exemple de réalisation plus détaillé, comme illustré sur la figure 9, le dispositif comprend alors :

- un substrat semi-conducteur 200, par exemple GaAs.
- une couche non linéaire 300, par exemple dans un matériau tel que GaAs, $Ga_xAl_{1-x}As$, $Ga_xIn_{1-x}P$,...

- un guide d'onde non linéaire dans le proche infrarouge 301, réalisé dans la couche 300, par exemple, une couche d'épaisseur de l'ordre du micron, et d'indice optique $n_2$ supérieur à l'indice optique $n_1$ de la couche 300). Par exemple si le matériau de cette couche 300 est $Ga_xAl_{1-x}As$, le guide d'onde peut être réalisé avec GaAs.

On a représenté le profil du mode guidé dans le proche infrarouge, noté IR sur la figure, et celui du mode terahertz, noté THZ.

On obtient un rayonnement terahertz $L_{THZ}$ qui sort verticalement par la surface du substrat 200.

On peut envisager un système d'émission terahertz comprenant une série de dispositifs de ce type, alignés sur un même substrat.

Un autre domaine d'application d'une structure optique selon l'invention, concerne les sources d'électrons, et plus particulièrement, les sources utilisant des cathodes froides à pointes émettrices. Dans ce contexte, la cathode est du type à émission de champ. Selon l'état de l'art, chaque zone émissive de la cathode se présente sous forme d'un cône (par exemple de tungstène) ou d'une pointe (par exemple un nanotube de carbone ou un nanofil métallique ou semiconducteur). Une telle cathode comporte un grand nombre de pointes émettrices, d'où le nom la structure correspondante FEA, acronyme anglo-saxon pour *Field Emission Array.*

Une source d'électrons correspondante comporte une cathode FEA et une grille situées à distance l'une de l'autre (typiquement de 1 à une centaine de $\mu$m), et entre lesquelles il règne un vide plus ou moins poussé. Une tension appliquée sur cette grille, de l'ordre de quelques dizaines à quelques centaines de volts, permet de créer un champ électrique externe E intense à la surface de chaque pointe de la cathode. La cathode émet un flux constant d'électrons, qui en est extrait par le champ électrique externe.

Une modulation de la tension ou du champ électrique E induit une modulation de la densité de courant J d'électrons émis suivant la loi de Fowler-Nordheim :

$$J = k_a E^2 \exp\left(-\frac{k_b}{E}\right)$$

où $k_a$ et $k_b$ sont des constantes.

Il est intéressant pour plusieurs applications de générer cette modulation de l'émission par une commande optique. Pour ce faire, il a été proposé (brevet français 04 13340) comme illustré schématiquement sur la figure 10a, de disposer un élément photoconducteur 401 entre chaque pointe émettrice 400 et le substrat conducteur 402 de la cathode (configuration 1). L'élément photoconducteur peut-être une diode, typiquement une diode PIN ou une résistance semi-conductrice. Dans une autre configuration illustrée sur la figure 10b (configuration 2), l'élément photoconducteur est une partie ou la totalité de la pointe émettrice 400. La pointe peut alors typiquement comprendre un nanofil ou nanotube d'un matériau conducteur photosensible. L'ensemble cathode grille étant polarisé par une tension constante sous un seuil d'émission significative, une modulation de l'éclairement L module l'impédance ou le courant dans le matériau photoconducteur, et donc le courant émis par la pointe.

Dans le cas où les pointes ont au sommet un diamètre nanométrique, il a également été proposé une autre configuration, selon laquelle on utilise le champ électrique de l'onde optique dans l'environnement proche de la pointe pour influer directement sur l' "émission de champ" des électrons depuis le sommet de la pointe, grâce à la caractéristique non-linéaire du processus d'émission de champ (effet de rectification optique). En modulant l'intensité de l'éclairement, il est possible de moduler la densité du courant émis (configuration 3). On se reportera par exemple à l'article M. Hagmann paru dans la revue IEEE Transaction on Microwave Theory and Techniques, Vol. 52 n°10, October 2004.

Enfin, une autre configuration est proposée dans ce même article (configuration 4), selon laquelle on utilise le battement de deux ondes optiques de longueurs d'onde très voisines pour constituer une onde optique résultante dont l'amplitude est modulée à une fréquence proche du THz, et de faire interagir cette onde avec les pointes émettrices comme il vient d'être dit. L'objectif est alors de constituer des faisceaux d'électrons modulés à une fréquence THz pour permettre la réalisation de tubes amplificateurs ou d'oscillateurs de puissance dans cette gamme de fréquences.

Dans les dispositifs à commande optique qui viennent d'être décrits, une grande partie de l'énergie lumineuse de commande est perdue dans le cas d'un éclairement uniforme, les éléments photosensibles étant petits et distants les uns des autres. Par ailleurs, dans le cas de la modulation directe de l'émission par le champ électrique de l'onde optique (configurations 3 et 4), l'éclairement habituellement en incidence quasi-normale, correspond à un champ électrique de l'onde optique perpendiculaire à l'axe des pointes, orientation inefficace pour influer sur l'émission de champ.

L'invention propose une solution à ces différents problèmes.

Une configuration d'un dispositif à émission de champ comprenant une structure optique selon l'invention est illustrée sur les figures 10c à 10f.

Le milieu de perméabilité diélectrique $\varepsilon_r$ positive est constitué par le vide ($\varepsilon_r=1$).

On utilise une structure optique son l'invention, avec une couche 500 de perméabilité diélectrique négative présentant une surface en relief en contact avec le vide ($\varepsilon_r$=1).

L'élément optique actif est ici un émetteur d'électrons, typiquement une pointe émettrice.

On place une pointe émettrice 510 sur la surface en relief de la couche 500, dans la zone de localisation en x et en y du champ électrique, c'est à dire dans la zone C, ou quand celle ci est de longueur nulle (profil $h_{II}(x)$), dans une région proche du plan de symétrie.

On obtient, par l'effet du couplage de l'onde incidente à un mode de surface, une réorientation du champ électrique de l'onde optique, qui devient parallèle à l'axe de la pointe émettrice.

L'invention permet une augmentation importante de la modulation de l'émission électronique dans les quatre configurations 1 à 4 connues décrites ci-dessus. Plus précisément, en utilisant une structure optique selon l'invention, on peut obtenir l'excitation d'un champ optique polarisé suivant l'axe des pointes à partir d'un faisceau à incidence quasiment normale. La modulation optique est ainsi très aisée à mettre en oeuvre dans le dispositif de source d'électrons.

Plus précisément, comme illustré sur la figure 10c, un dispositif à émission de champ comprend une structure optique, comprenant au moins une couche de perméabilité diélectrique négative 500 présentant une surface en relief selon l'invention, en contact avec le vide. La période A de la structure optique est proche de la longueur d'onde de l'onde optique contrôlant l'émission de champ.

Les pointes émettrices 510 sont orientées selon -0y. Ces pointes peuvent être en partie ou en totalité en matériau photoconducteur, comme illustré sur la figure 10b, ou comprendre à la base, entre la couche 500 et la pointe elle-même, un élément conducteur photosensible comme illustré sur la figure 10a, par exemple une photodiode ou une résistance photoconductrice.

Ces pointes sont disposées sur la couche 500, dans la zone de localisation de champ en x et y.

De préférence, elles sont disposées à proximité du point d'amplitude maximum de la composante Ey du champ. Ceci peut varier selon le profil de la surface en relief, et des paramètres a, b, c, d, $h_g$ du motif élémentaire.

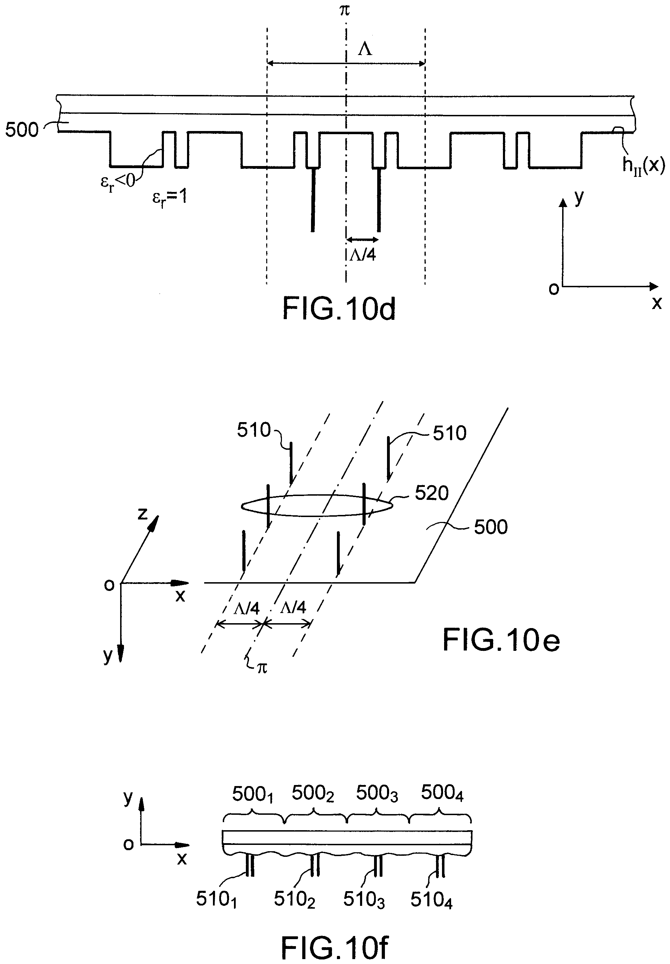

On montre qu'un emplacement de la pointe 510 à une distance suivant 0x de l'ordre de A/4 d'un côté ou de l'autre du plan de symétrie $\Pi$ offre de bonnes performances. On peut même prévoir une paire de pointes 520, avec une pointe à égale distance de part et d'autre du plan $\Pi$, et de préférence à une distance proche de A/4 de ce plan, comme illustré dans la configuration illustrée sur la figure 10c, avec une surface en relief de type $h_I(x)$, ou sur la figure 10d, avec un profil de type $h_{II}(x)$.

La structure étant invariante selon 0z, des pointes 510, ou des paires de pointes 520 sont disposées, alignées selon 0z (figure 10e) sur la surface en relief de la couche 500.

On peut encore réaliser une matrice d'émetteurs d'électrons, avec autant de structures optiques $500_1$, $500_2$... que de rangées de pointes $510_1$, $510_2$, ou de paires de pointes $520_1$, $520_2$ désirées, comme illustré schématiquement sur la figure 10f. Ces structures optiques $500_i$ sont avantageusement contiguës, comme illustré, pour ne pas avoir de perte de lumière entre ces structures.

Dans une variante de l'invention, sous l'emplacement des pointes, on a un dispositif photoconducteur ( PIN ou autre) directement sur le substrat qui peut être alors être avantageusement un semi-conducteur très dopé, selon la configuration de la figure 10a.

Une mise en oeuvre avantageuse de l'invention comprend l'utilisation de nano-émetteurs tels que des nanofils semi-conducteurs ou des nanotubes de carbone comme pointes émettrices d'électrons. Ces nano-émetteurs ont en effet un facteur de forme très favorable, qui a comme effet de renforcer d'au moins deux ordres de grandeur le champ électrique local à l'extrémité de ces nano-émetteurs, par rapport au champ moyen. Cela permet d'obtenir une émission efficace d'électrons, sous faibles champs électriques appliqués.

Dans un perfectionnement, on prévoit que le profil de la structure est paramétré de manière à être très résonnant Cette forte résonance permet d'obtenir un champ électromagnétique de surface dont l'amplitude peut être supérieure d'au moins un ordre de grandeur à l'amplitude du champ optique incident. Ce qui implique une contribution à l'émission du courant d'électrons qui est au moins de deux ordres de grandeur.

Avantageusement, par l'effet de la rectification optique, la structure optique selon l'invention permet aussi la conversion d'un signal de battement entre deux fréquences optiques, en une modulation dans le domaine de THz de l'émission électronique. La source électronique comprend alors deux sources optiques, typiquement deux sources lasers émettant à des fréquences proches.

Selon un autre aspect avantageux de l'invention, la structure optique permettant d'augmenter le champ électrique au voisinage des nano-émetteurs, l'intensité optique est aussi augmentée, typiquement d'un facteur 100 à 1000. Il en résulte une modulation de la photoconductivité du nano-émetteur.

Dans un exemple de réalisation pratique, on pourra procéder de la façon suivante pour réaliser un dispositif à émission de champ selon l'invention.

On prend un substrat, qui peut être un matériau semi-conducteur ou métallique. On réalise la structure optique selon l'invention. Par exemple on dépose une couche de matériau diélectrique que l'on grave ensuite selon le profil approprié. Puis on fait un dépôt de la couche de métal. Par exemple, le métal est de l'or.

Sur la structure optique ainsi réalisée, on dépose une couche de résine, que l'on grave à l'emplacement prévu de chaque pointe émettrice 510, en sorte de dégager cette zone pour y déposer un matériau compatible avec la pointe émettrice. Dans un exemple, si la pointe est un nanotube de carbone, on réalise ainsi une barrière de diffusion, typiquement un dépôt TiN, et un catalyseur (Ni, Co, Fe ....) sur la zone de défaut. On peut alors procéder à la croissance CVD du nanotube de carbone.

Cette pointe peut aussi être un nanofil semi-conducteur (ou une pluralité de nanofils). Cette pointe est déposée par tout moyen approprié selon l'état de l'art, sur la zone de défaut, sur laquelle on aura déposé au préalable un matériau compatible avec le nanofil.

## Revendications

1. Dispositif comprenant au moins un élément optique actif disposé dans un milieu de perméabilité diélectrique positive et, à proximité dudit élément actif, une structure optique comprenant une couche d'un matériau de perméabilité diélectrique négative, ladite couche présentant, repérée dans un référentiel orthogonal 0xyz, une surface ayant un relief $y=h(x,z)$ invariant selon 0z et variable selon 0x, l'axe 0y étant orienté depuis le milieu de perméabilité diélectrique positive vers ladite couche de perméabilité diélectrique négative, ladite surface étant en contact avec ledit milieu de perméabilité diélectrique positive et comprenant une première zone de relief (A), ayant un profil en coupe selon 0xy qui comprend une répétition périodique d'un motif élémentaire (ME) et une deuxième zone de relief (B) symétrique de ladite première zone (A) par rapport à un plan de symétrie ($\Pi$) parallèle à Oyz, lesdites première et deuxième zones étant séparées par une troisième zone (C) disposée au centre de la structure et créant en comparaison avec lesdites première et deuxième zones (A,B), un défaut de périodicité de la surface en relief, **caractérisé en ce que** ledit motif élémentaire est défini par quatre portions successives, une première portion ($p_a$) de largeur à mi-hauteur a et une deuxième portion ($p_b$) de largeur à mi-hauteur b, une troisième portion ($p_c$) de largeur à mi-hauteur c et une quatrième portion ($p_d$) de largeur à mi-hauteur d, les première et troisième portions étant sensiblement de même hauteur $h_t$, les deuxième et quatrième portions étant sensiblement de même hauteur $h_d$ différente de $h_t$, avec $h_t$ strictement supérieur à $h_d$ et **en ce que** a, b, c, d et $h_g = |h_t - h_d|$ sont des paramètres du profil choisis tels que :

   - chacun est non nul,
   - la somme a+b+c+d est égale à la période $\Lambda$ et
   - au moins a$\neq$c ou b$\neq$d.

2. Dispositif selon la revendication 1, **caractérisé en ce que** lesdites portions forment un motif binaire.

3. Dispositif selon la revendication 1 ou 2, **caractérisé en ce que** ladite troisième zone ($C_1$) a une longueur (I) égale à un nombre m entier non nul de périodes $\Lambda$.

4. Dispositif selon la revendication 3, **caractérisé en ce que** ladite troisième zone ($C_1$) débute en un point de position $x_1$ sur l'axe 0x correspondant sensiblement au milieu d'une première portion ($p_a$) d'un motif élémentaire de ladite première zone ($A_1$) et se termine en un point de position $x_2$ sur l'axe 0x correspondant sensiblement au milieu d'une première portion ($p_a$) d'un motif élémentaire de ladite deuxième zone ($B_1$), et **en ce que** ledit motif élémentaire (ME) pouvant être décrit par une série de Fourier à amplitudes complexes, les paramètres a, b, c, d et $h_g$ sont choisis tels que :

   - entre un harmonique d'ordre un ($f(x,y,\Lambda)$) et un harmonique d'ordre deux ($g(x,y, \frac{1}{2}\Lambda)$) de ladite série de Fourier, il existe un déphasage relatif ($\delta\Lambda$) sensiblement nul et
   - l'amplitude complexe de la première harmonique non nulle d'ordre supérieur à 2 est négligeable devant les amplitudes complexes des harmoniques d'ordre un ($f(x,y,\Lambda)$) et d'ordre deux ($g(x,y, \frac{1}{2}\Lambda)$).

5. Dispositif selon l'une des revendications 3 ou 4, **caractérisé en ce que** ladite troisième zone (C) a un relief sensiblement plan suivant 0xz sur toute sa longueur et **en ce que** les paramètres a, b, c et d vérifient les relations suivantes :

   - a$\neq$c et
   - b=d.

6. Dispositif selon la revendication 1 ou 2, **caractérisé en ce que** ladite troisième zone (C) a une longueur nulle suivant 0x.

7. Dispositif selon la revendication 6, **caractérisé en ce que** lesdites première zone ($A_2$) et deuxième zone ($B_2$) sont

telles que :

- la première zone ($A_2$) comprend un nombre N/2 fois la réplique d'un motif ($ME_{XP}$), ledit motif ($ME_{XP}$) étant défini à partir d'une suite périodique du motif élémentaire (ME) entre un point (P) de position $x_p$ sur l'axe 0x et un point (P') de position $x_p+\Lambda$ sur l'axe 0x, ledit point (P) de position $x_p$ étant tel que l'équation suivante soit vérifiée :

$$\int_{x_p}^{x_p+\Lambda} h_{II}(x).\sin\left(\frac{2\pi.x}{\Lambda}\right).dx = 0$$

où $h_{II}(x)$ est la hauteur suivant 0y du profil en un point x de l'intervalle $[x_p, x_p+\Lambda]$;
- la deuxième zone ($B_2$) est obtenue par duplication de ladite première zone suivant une opération de symétrie par rapport au dit plan de symétrie ($\Pi$) ;

et **en ce que** ledit motif élémentaire (ME) pouvant être décrit par une série de Fourier à amplitudes complexes, les paramètres a, b, c, d et $h_g$ sont choisis tels que :

- entre un harmonique d'ordre un ($f(x,y,\Lambda)$) et un harmonique d'ordre deux ($g(x,y, ½\Lambda)$) de ladite série de Fourier, il existe un déphasage relatif ($\delta\Lambda$) sensiblement égal à A/4 et
- l'amplitude complexe d'au moins un harmonique parmi les harmoniques d'ordre supérieur à deux, est négligeable devant les amplitudes complexes des harmoniques d'ordre un ($f(x,y,\Lambda)$) et d'ordre deux ($g(x,y, ½\Lambda)$).

8.  Dispositif selon l'une quelconque des revendications 1 à 7, **caractérisé en ce que** :

- ledit milieu de perméabilité diélectrique positive est un matériau de type semi-conducteur;
- ledit élément optique actif est une zone de photo-détection (21) disposée dans une couche (20) dudit matériau, centrée par rapport à ladite troisième zone (C), apte à fournir un signal électrique correspondant à la détection d'une onde électromagnétique d'une longueur d'onde déterminée, et
- la période A de la structure optique, multipliée par l'indice de réfraction de ladite couche (20), est proche de ladite longueur d'onde.

9.  Dispositif selon la revendication 8, en combinaison avec un profil suivant l'une des revendications 3 à 6, **caractérisé en ce que** la structure optique (110) comprend une couche de semi-conducteur dopée (111) de perméabilité diélectrique positive, et une première couche (112) et une deuxième couche (113) de matériau de perméabilité diélectrique négative, ladite première couche (112) présentant une surface en relief dans laquelle la troisième zone (C) est formée par un trou dans cette couche **en ce que** l'élément optique actif (120) est disposé directement sur ladite couche de matériau semi-conducteur dopé (111), ladite couche (111) se trouvant à un niveau au-dessus de la première couche (112) dans cette troisième zone (C) et la deuxième couche (113) de matériau de perméabilité diélectrique négative étant disposée au-dessus de l'élément optique actif, et isolée électriquement de la première couche 112.

10.  Matrice photosensible comprenant une pluralité de photodétecteurs, **caractérisé en ce que** lesdits photodétecteurs sont des dispositifs selon l'une quelconque des revendications 8 et 9.

11.  Dispositif selon l'une quelconque des revendications 1 à 7, **caractérisé en ce que** :

- le milieu de perméabilité diélectrique positive est un matériau de type semi-conducteur,
- ledit élément optique actif est une couche active (210) dudit matériau permettant un gain optique et une émission laser,
- la période $\Lambda$, multiplié par l'indice de réfraction de la couche 20, est proche de la longueur d'onde émise,

ledit dispositif permettant une extraction verticale de l'émission laser.

12.  Dispositif selon la revendication 11 en combinaison avec la revendication 4 ou 7, **caractérisé en ce que** les paramètres a, b, c, d et $h_g$ de ladite structure optique sont choisis tels que le deuxième harmonique d'ordre 2 ($g(x,y,½\Lambda)$) de la série de Fourier associée au profil du motif élémentaire a une amplitude complexe ($\beta$) très supérieure à l'amplitude complexe ($\alpha$) de l'harmonique d'ordre 1 ($f(x,y,\Lambda)$).

**13.** Dispositif selon la revendication 11 ou 12, **caractérisé en ce qu'**il comprend en outre au moins une couche (211) ayant un indice optique plus faible que l'indice optique de la couche active (210).

**14.** Matrice photo-émettrice comprenant une pluralité de dispositifs photo-émetteurs d'un faisceau laser réalisés sur un même substrat (S), **caractérisée en ce que** lesdits dispositifs photo-émetteurs sont des dispositifs selon l'une quelconque des revendications 11 à 13.

**15.** Dispositif selon l'une quelconque des revendications 1 à 7, **caractérisé en ce que** :

- le milieu de perméabilité diélectrique positive est un matériau de type semi-conducteur,
- ledit matériau comprenant un élément optique actif constitué d'une couche (300) d'un matériau non linéaire transparent à des longueurs d'onde d'une gamme proche infrarouge et terahertz, ladite couche (300) comportant un guide d'onde non linéaire (301) transparent aux dites longueurs d'onde, et ayant une perméabilité diélectrique positive plus grande que celle de ladite couche (300),
- la période $\Lambda$, multipliée par un indice de réfraction moyen de ladite couche (300), a une valeur proche d'une longueur d'onde terahertz, ledit dispositif permettant une émission verticale d'une onde terahertz à la dite longueur d'onde terahertz, générée par conversion de fréquence optique, en réponse à un éclairement du guide d'onde suivant l'axe 0x sous une première et une deuxième fréquences optiques ($\omega_1$, $\omega_2$) différentes du domaine proche infra-rouge.

**16.** Dispositif selon la revendication 15, en combinaison avec la revendication 4 ou 7, **caractérisé en ce que** les paramètres a, b, c, d et $h_g$ de la structure optique sont choisis tels que le deuxième harmonique d'ordre 2 (g(x,y,½$\Lambda$)) de la série de Fourier associée au profil du motif élémentaire a une amplitude complexe ($\beta$) très supérieure à l'amplitude complexe ($\alpha$) de l'harmonique d'ordre 1 (f(x,y,$\Lambda$)).

**17.** Dispositif selon l'une quelconque des revendications 1 à 7, **caractérisé en ce qu'**il comprend au moins un élément optique actif, et **en ce que**

- ledit milieu de perméabilité diélectrique positive est le vide;
- ledit élément optique actif est un émetteur d'électrons (510) à effet de pointe, émettant suivant l'axe -0y, l'émission d'électrons étant contrôlée par une onde optique,
- la période A de la structure optique (500) est proche de la longueur d'onde de ladite onde optique.

**18.** Dispositif selon la revendication 17, **caractérisé en ce que** ledit émetteur comprend un élément photoconducteur disposé au voisinage de la structure optique, l'émission d'électrons étant contrôlée par la photoconductivité dudit élément.

**19.** Dispositif selon la revendication 18, **caractérisé en ce que** ledit émetteur (510) comprend un nanofil ou un nanotube, orienté suivant -Oy, d'un matériau conducteur photosensible, qui constitue ledit élément photoconducteur.

**20.** Dispositif selon l'une quelconque des revendications 17 à 19, **caractérisé en ce que** ledit émetteur est disposé à proximité du plan de symétrie ($\Pi$), à une distance dudit plan suivant 0x de l'ordre de A/4.

**21.** Dispositif selon l'une quelconque des revendications 17 à 20, **caractérisé en ce qu'**il comprend un premier et un deuxième émetteurs disposés de part et d'autre du plan de symétrie ($\Pi$), chacun à environ A/4 dudit plan selon 0x.

**22.** Dispositif selon l'une des revendications 17 à 21, **caractérisé en ce qu'**il comprend une pluralité d'émetteurs d'électrons alignés selon 0z, dans ladite troisième zone.

**23.** Dispositif selon l'une des revendications 17 à 22, **caractérisé en ce que** l'émission d'électrons est contrôlée par le champ électrique de l'onde optique, la structure optique ayant pour effet une ré-orientation de ce champ électrique dans l'axe d'émission de l'émetteur, **en ce que** ledit émetteur d'électron comprend un nanotube de carbone ou un nanofil semi-conducteur ou métallique et **en ce qu'**il comprend une première et une deuxième sources optiques incidentes, pour générer un signal terahertz.

**24.** Source d'émission d'électrons à modulation optique de champ électrique comprenant un dispositif d'émission d'un faisceau d'électrons selon l'une quelconque des revendications 17 à 23.

**Patentansprüche**

1. Vorrichtung, die mindestens ein aktives optisches Element enthält, das in einem Milieu mit positiver dielelektrischer Permeabilität angeordnet ist und, in Nähe dieses aktiven Elementes, eine aktive Struktur, die eine Schicht eines Materials mit negativer dielelektrischer Permeabilität umfasst, diese Schicht weist, markiert in einem orthogonalen Bezugsrahmen Oxyz, eine Fläche auf, mit einem Relief $y=h(x,z)$, unveränderlich nach Oz und variabel nach Ox, die Achse Oy ist von der Mitte der positiven dielelektrischen Permeabilität zu dieser Schicht mit negativer dielelektrischer Permeabilität orientiert, wobei diese Fläche Kontakt mit dem genannten Milieu mit positiver dielelektrischer Permeabilität hat und umfasst eine erste Reliefzone (A), die ein Profil im Schnitt nach Oxy aufweist, das eine regelmäßige Wiederholung eines elementaren Elementes ($M_E$) umfasst und eine zweite Reliefzone (B), symmetrisch zu dieser ersten Zone (A), bezogen auf eine Symmetrieebene ($\Pi$), parallel zu Oyz, diese erste und zweite Zone sind voneinander durch eine dritte Zone (C) getrennt, die im Zentrum der Struktur angeordnet ist und die im Vergleich mit dieser ersten und zweiten Zone (A, B) einen Periodizitätsfehler der Reliefoberfläche aufweist, **dadurch gekennzeichnet, dass** dieses elementare Muster definiert ist durch vier aufeinanderfolgende Teilstücke, ein erstes Teilstück ($p_a$) mit einer Breite der halben Höhe a und eine zweites Teilstück ($p_b$) mit einer Breite der halben Höhe b, ein drittes Teilstück ($p_c$) mit einer Breite der halben Höhe c und ein viertes Teilstück ($p_d$) mit einer Breite der halben Höhe d, das erste und dritte Teilstück haben deutlich dieselbe Höhe $h_t$, das zweite und vierte Teilstück haben deutlich dieselbe Höhe $h_d$, die sich von $h_t$ unterscheidet, wobei $h_t$ strikt höher sein muss als $h_d$ und dadurch dass a, b, c, d und $h_g = |h_t - h_d|$ Profilparameter sind, ausgewählt danach dass:

   - jeder nicht gleich Null ist,
   - die Summe a+b+c+d ist gleich der Periode A und
   - mindestens $a \neq c$ oder $b \neq d$.

2. Vorrichtung gemäß Anspruch 1, **dadurch gekennzeichnet, dass** diese Teilstücke ein binäres Muster bilden.

3. Vorrichtung gemäß Anspruch 1 oder 2, **dadurch gekennzeichnet, dass** diese dritte Zone ($C_1$) eine Länge (1) hat, gleich einer ganzen Zahl m ungleich Null der Perioden A ist.

4. Vorrichtung gemäß Anspruch 3, **dadurch gekennzeichnet, dass** diese dritte Zone ($C_1$) an einem Punkt $x_1$ auf der Ox-Achse beginnt, der deutlich der Mitte eines ersten Teilstücks ($p_a$) eines elementaren Musters dieser ersten Zone ($A_1$) entspricht und an einem Punkt $x_2$ auf der Achse Ox endet, die deutlich der Mitte eines ersten Teilstücks ($p_a$) eines elementaren Musters dieser zweiten Zone ($B_1$) entspricht und dadurch dass dieses elementare Muster ($M_E$) durch eine Fourier - Reihe mit komplexen Amplituden beschrieben werden kann, die Parameter a, b, c, d und $h_g$ werden ausgewählt wie:

   - zwischen einer Harmonischen der Größenordnung eins ($f(x, y, \Lambda)$) und einer Harmonischen der Größenordnung zwei ($g(x, y, 1/2\Lambda)$) dieser Fourier - Reihe, gibt es eine relative Phasenverschiebung ($\delta\Lambda$) die deutlich Null ist und
   - die komplexe Amplitude der ersten Harmonischen ungleich Null der Größenordnung über 2, ist zu vernachlässigen angesichts der komplexen Amplituden der Harmonischen der Größenordnung eins ($f(x, y, \Lambda)$) und der Größenordnung zwei ($g(x, y, 1/2 \Lambda)$).

5. Vorrichtung gemäß einem der Ansprüche 3 oder 4, **dadurch gekennzeichnet, dass** diese dritte Zone (C) ein deutlich ebenes Relief entlang Oxz über ihre gesamte Länge aufweist und dass die Parameter a, b, c und d die folgenden Gleichungen prüfen:

   - $a \neq c$ und
   - $b \neq d$.

6. Vorrichtung gemäß einem der Ansprüche 1 oder 2, **dadurch gekennzeichnet, dass** diese dritte Zone (C) eine Länge gleich Null nach Ox hat.

7. Vorrichtung gemäß Anspruch 6, **dadurch gekennzeichnet, dass** diese erste Zone ($A_2$) und die zweite Zone ($B_2$) derart sind, dass:

   - die erste Zone ($A_2$) eine Zahl N/2- mal die Replik eines Musters ($M_{Exp}$) umfasst, dieses Muster ($M_{Exp}$) wird definiert ausgehend von einer periodischen Folge des elementaren Musters ($M_E$) zwischen einem Punkt der Position $x_p$ auf der Achse 0x und einen Punkt (P') der Position $x_p + A$ auf der Achse Ox, dieser Punkt der Position

$x_p$ ist so, dass die folgende Gleichung überprüft wird:

$$\int_{x_p}^{x_p+\Lambda} h_{\Pi}(x).\sin\left(\frac{2\pi.x}{\Lambda}\right).dx = 0$$

worin $h_{\Pi}(x)$ die Höhe nach Oy des Profils in einem Punkt x des Intervalls $[x_p, x_p + A]$ ist;
- die zweite Zone (B2) ergibt sich durch Duplikation dieser ersten Zone, nach einer Symmetrieoperation bezogen auf diese Symmetrieebene ($\Pi$);

und dadurch dass dieses elementare Muster (ME) durch eine Fourier - Reihe mit komplexen Amplituden beschrieben werden kann, die Parameter a, b, c, d und $h_g$ werden ausgewählt:

- zwischen einer Harmonischen der Größenordnung eins ($f(x, y, \Lambda)$) und einer Harmonischen der Größenordnung zwei ($g(x, y, 1/2 \Lambda)$) dieser Fourier - Reihe, gibt es eine relative Phasenverschiebung ($\delta\Lambda$) die deutlich gleich A /4 ist und die komplexen Amplitude mindestens einer Harmonischen unter den Harmonischehn in der Größenordnung über 2 ist zu vernachlässigen, angesichts der komplexen Amplituden der Harmonischen der Größenordnung eins ($f(x, y, \Lambda)$) und zwei ($g(x, y, 1/2 \Lambda)$).

8. Vorrichtung nach irgendeinem der Ansprüche 1 bis 7, **dadurch gekennzeichnet, dass**:

   - dieses Milieu mit positiver dielektrischer Permeabilität ein Material vom Typ Halbleiter ist;
   - dieses aktive optische Element eine Fotodetektionsschicht (21) ist, angeordnet in einer Schicht (20) dieses Materials, zentriert, bezogen auf diese dritte Zone (C), in der Lage ein elektrisches Signal auszusenden, dass der Detektion einer elektromagnetischen Welle mit einer bestimmten Wellenlänge entspricht, und
   - die Periode A der optischen Struktur, multipliziert mit dem Refraktionsindex dieser Schicht (20) liegt in der Nähe dieser Wellenlänge.

9. Vorrichtung gemäß Anspruch 8, in Kombination mit einem Profil gemäß einem der Ansprüche 3 bis 6, **dadurch gekennzeichnet, dass** die optische Struktur (110) eine Schicht mit einem dotierten Halbleiter (111) mit positiver dielelektrischer Permeabilität umfasst, sowie eine erste (112) und eine zweite Schicht (113) eines Materials mit negativer dielelektrischer Permeabilität, diese erste Schicht (112) weist eine Reliefoberfläche auf, in der die dritte Zone (C) durch ein Loch in dieser Schicht gebildet wird, dadurch dass das aktive optische Element (120) direkt auf dieser Schicht dotierten Halbleitermaterials (111) angeordnet wird, diese Schicht (111) befindet sich auf einem Niveau über der ersten Schicht (112), in dieser dritten Zone (C) und die zweite Schicht (113) aus einem Material mit negativer dielelektrischer Permeabilität ist über dem aktiven optischen Element angeordnet und elektrisch von der ersten Schicht 112 isoliert.

10. Lichtempfindliche Matrix, mit mehreren Fotodetektoren, **dadurch gekennzeichnet, dass** es sich bei diesen Fotodetektoren um Vorrichtungen nach irgendeinem der Ansprüche 8 und 9 handelt.

11. Vorrichtung nach irgendeinem der Ansprüche 1 bis 7, **dadurch gekennzeichnet, dass**:

    - das Milieu mit positiver dielektrischer Permeabilität ein Material vom Typ Halbleiter ist;
    - dieses aktive optische Element eine aktive Schicht (210) dieses Materials ist, das eine optische Verstärkung und eine Laseremission ermöglicht,
    - die Periode A, multipliziert mit dem Refraktionsindex dieser Schicht (20) ist nahe der emittierten Wellenlänge.
    - diese Vorrichtung erlaubt eine vertikale Extraktion der Lasememission.

12. Vorrichtung gemäß Anspruch 11, kombiniert mit Anspruch 4 oder 7, **dadurch gekennzeichnet, dass** die Parameter a, b, c, d und $h_g$ dieser optischen Struktur derart ausgewählt werden, dass die zweite Harmonische der Größenordnung 2 ($g(x,y, \frac{1}{2}\Lambda)$) der Fourier - Reihe, verbunden mit dem Profil des elementaren Motivs, eine komplexe Amplitude ($\beta$), weit höher als die komplexe Amplitude ($\alpha$) der Harmonischen der Größenordnung 1 ($f(x,y, \Lambda)$) hat.

13. Vorrichtung gemäß Anspruch 11 oder 12, **dadurch gekennzeichnet, dass** es außerdem mindestens eine Schicht (211) enthält, die einen optischen Index hat, der schwächer ist, als der optische Index der aktiven Schicht (210).

14. Lichtemittierende Matrix, mit mehreren lichtemittierenden Vorrichtungen eines Laserstrahls, ausgeführt auf demselben Substrat (S), **dadurch gekennzeichnet, dass** diese lichtemittierenden Vorrichtungen, Vorrichtungen gemäß irgendeinem der Ansprüche 11 bis 13 sind.

15. Vorrichtung nach irgendeinem der Ansprüche 1 bis 7, **dadurch gekennzeichnet, dass**:

- das Milieu mit positiver dielektrischer Permeabilität ein Material vom Typ Halbleiter ist;
- dieses Material ein aktives optisches Element enthält, bestehend aus einer Schicht (300) eines nicht linearen Materials, transparent für Wellenlängen im Bereich nach dem Infrarot- und Terahertz - Bereich, diese Schicht (300) umfasst einen nicht linearen Wellenleiter (301), transparent für die genannten Wellenlängen und mit einer positiven dielektrischen Permeabilität die größer ist, als die der genannten Schicht (300),
- die Periode $\Lambda$, multipliziert mit einem durchschnittlichen Brechungsindex dieser Schicht (300), hat einen Wert nahe einer Terahertz - Wellenlänge, diese Vorrichtung erlaubt die vertikale Emission einer Terahertz - Welle mit der genannten Terahertz - Wellenlänge, erzeugt durch Umwandlung optischer Frequenzen, in Reaktion auf eine Beleuchtung des Wellenleiters entlang der Achse Ox unter einer ersten und einer zweiten optischen Frequenz ($\omega1$, $\omega2$), die sich vom Bereich nahe Infrarot unterscheiden.

16. Vorrichtung gemäß Anspruch 15, kombiniert mit Anspruch 4 oder 7, **dadurch gekennzeichnet, dass** die Parameter a, b, c, d und $h_g$ dieser optischen Struktur derart ausgewählt werden, dass die zweite Harmonische der Größenordnung 2 (g(x,y, ½$\Lambda$)) der Fourier - Reihe, verbunden mit dem Profil des elementaren Motivs eine komplexe Amplitude ($\beta$) weit über der komplexen Amplitude ($\alpha$) der Harmonischen der Größenordnung 1 (f(x,y, $\Lambda$)) hat.

17. Vorrichtung gemäß irgendeinem der Ansprüche 1 bis 7, **dadurch gekennzeichnet, dass** sie mindestens ein aktives optisches Element umfassst und dadurch dass

- diese Milieu mit positiver dielektrischer Permeabilität das Vakuum ist;
- dieses optische Element ein Elektronenemitter (510) ist, mit Spitzenwirkung, emittierend nach der Achse -Oy, die Elektronenemission wird dabei von einer optischen Welle kontrolliert,
- Periode A der optischen Struktur (500) nahe der Wellenlänge dieser optischen Welle ist.

18. Vorrichtung gemäß Anspruch 17, **dadurch gekennzeichnet, dass** dieser Emitter ein lichtleitendes Element enthält, dass in der Nachbarschaft der optischen Struktur angeordnet ist, die Elektronenemission wird durch die Lichtleitfähigkeit dieses Elementes kontrolliert.

19. Vorrichtung gemäß Anspruch 18, **dadurch gekennzeichnet, dass** dieser Emitter (510) einen Nanodraht oder ein Nanoröhrchen umfasst, ausgerichtet nach - Oy, aus einem lichtempfindlichen, leitenden Material, das dieses lichtleitende Element bildet.

20. Vorrichtung gemäß irgendeiner der Ansprüche 17 bis 19, **dadurch gekennzeichnet, dass** dieser Emitter in der Nähe der Symmetrieebne ($\Pi$) in einem Abstand zu dieser Ebene laut Ox in der Größenordnung von $\Lambda$/4 angeordnet ist.

21. Vorrichtung gemäß irgendeiner der Ansprüche 17 bis 20, **dadurch gekennzeichnet, dass** sie einen ersten und einen zweiten Emitter umfasst, die beiderseits der Symmetrieebne ($\Pi$) angeordnet sind, jeder in ungefähr $\Lambda$/4 von dieser Ebene nach Ox.

22. Vorrichtung gemäß irgendeinem der Ansprüche 17 bis 21, **dadurch gekennzeichnet, dass** sie mehrere Elektronenemitter umfasst, angeordnet nach Oz in der genannten dritten Zone.

23. Vorrichtung gemäß irgendeinem der Ansprüche 17 bis 22, **dadurch gekennzeichnet, dass** die Elektronenemission durch das elektrische Feld der optischen Welle kontrolliert wird, die optische Struktur bewirkt eine Neuorientierung dieses elektrischen Feldes in der Emissionsachse des Emitters, dadurch dass dieser Elektronenemitter ein Nanoröhrchen aus Kohlenstofff oder einen Halbleiter - oder Metall - Nanodraht umfasst und dadurch dass er eine erste und eine zweite einfallende optische Quelle umfasst, um ein Terahertz - Signal zu erzeugen.

24. Elektronen emissionsquelle mit optischer Modulation des elektrischen Feldes, umfassend eine Vorrichtung zur Emission eines Elektronenstrahls, gemäß irgendeinem der Ansprüche 17 bis 23.

**Claims**

1. Device including at least one active optical member provided in a medium of positive dielectric permeability and, in the proximity of said active member, an optical structure including a layer of a material of negative dielectric permeability, said layer having, located in an orthogonal reference frame 0xyz, a surface having a relief y=h(x,z) invariant along 0z and variable along 0x, the 0y axis being oriented from the positive dielectric permeability medium to said layer of negative dielectric permeability, said surface contacting said positive dielectric permeability medium and including a first relief area (A), having a profile in 0xy cross section that includes a periodic repetition of a unit pattern (ME) and a second relief area (B) symmetrical to said first area (A) with respect to a plane of symmetry (Π) parallel to 0yz, said first and second areas being separated by a third layer (C) provided in the centre of the structure, giving rise, compared with said first and second areas (A,B), to a fault in periodicity of the relief surface, **characterised in that** said unit pattern is defined by four succeeding portions, a first portion ($p_a$) of full width at half maximum a and a second portion ($p_b$) of full width at half maximum b, a third portion ($p_c$) of full width at half maximum c and a fourth portion ($p_d$) of full width at half maximum d, said first and third portions having substantially the same height $h_t$, said second and fourth portions having substantially the same height $h_d$ different from $h_t$, with $h_t$ strictly higher than $h_d$ and **in that** a, b, c, d and hg= $h_t$- $h_d$ are selected profile parameters such that :

   - each of them is not zero,
   - the sum a+b+c+d is equal to the period A and
   - at least a≠c or b≠d.

2. Device according to claim 1, **characterised in that** said portions form a binary pattern.

3. Device according to claim 1 or 2, **characterised in that** said third area ($C_1$) has a length (l) equal to a non zero integer m of periods A.

4. Device according to claim 3, **characterised in that** said third area ($C_1$) starts in a point of position $x_1$ on the 0x axis substantially corresponding to the middle of a first portion ($p_a$) of a unit pattern of said first area ($A_1$) and ends in a point of position $x_2$ in the 0x axis substantially corresponding to the middle of a first portion ($p_a$) of a unit pattern of said second area ($B_1$), and **in that** said unit pattern (ME) can be described by a Fourier series with complex amplitudes, the parameters a, b, c, d and $h_g$ being chosen so that:

   - between an harmonic of first order (f(x,y,Λ)) and an harmonic of second order (g(x,y, ½Λ)) of said Fourier series, there is a relative phase shift (δΛ) substantially null and
   - the complex amplitude of the first non zero harmonic of order higher than 2 is negligible with respect to the complex amplitudes of the harmonics of first order (f (x,y,Λ)) and of second order (g(x,y, ½Λ)).

5. Device according to any of claim 3 or 4, **characterised in that** said third area (C) has a relief substantially planar along 0xz throughout its length and **in that** the parameters a, b, c and d satisfy the following relationships:

   - a≠c and
   - b=d.

6. Device according to claim 1 or 2, **characterised in that** said third area (C) has a null length along 0x.

7. Device according to claim 6, **characterised in that** said first area ($A_2$) and second area ($B_2$) are such that:

   - the first area ($A_2$) includes a number N/2 times the replica of a pattern ($ME_{XP}$), said pattern ($ME_{XP}$) being defined from a periodical sequence of the unit pattern (ME) between a point (P) of position $x_p$ on the 0x axis and a point (P') of position $x_p$+Λ on the 0x axis, said point (P) of position $x_p$ being such that the following equation is satisfied:

$$\int_{x_p}^{x_p+\Lambda} h_{\Pi}(x).\sin\left(\frac{2\pi.x}{\Lambda}\right).dx = 0$$

   where $h_{\Pi}(x)$ is the height along 0y of the profile in a point x of the interval [$x_p$, $x_p$+Λ];
   - the second area ($B_2$) is obtained through duplicating the first area following a symmetry operation with respect to said plane of symmetry ($\Pi$);

and **in that** said unit pattern (ME) can be described by a Fourier series with complex amplitudes, the parameters a, b, c, d and $h_g$ being chosen so that:

- between an harmonic of first order (f(x,y,$\Lambda$)) and an harmonic of second order (g(x,y, $\frac{1}{2}\Lambda$)) of said Fourier series, there is a relative phase shift ($\delta\Lambda$) substantially equal to A/4 and
- the complex amplitude of at least one harmonic from the harmonics of order higher than two, is negligible with respect to the complex amplitudes of the harmonics of first order (f (x,y,$\Lambda$)) and of second order (g(x,y, $\frac{1}{2}\Lambda$)).

8. Device according to any of claims 1 to 7, **characterised in that**:

- said medium of positive dielectric permeability is a semi-conductor type material;
- said active optical member is a photodetecting area (21) provided in a layer (20) of said material, centred with respect to said third area (C), able to provide an electrical signal corresponding to the detection of an electromagnetic wave of a determined wavelength, and
- the period A of the optical structure, multiplied by refractive index of said layer (20), is close to said wavelength.

9. Device according to claim 8, in combination with a profile according to any of claims 3 to 6, **characterised in that** the optical structure (110) includes a doped semi-conducting layer (111) of positive dielectric permeability, and a first layer (112) and a second layer (113) of a material of negative dielectric permeability, said first layer (112) having a relief surface in which the third area (C) is formed by a hole in this layer and **in that** the active optical member (120) is directly provided on said layer of doped semi-conducting material (111), said layer (111) being at a level above the first layer (112) in this third area (C) and second layer (113) of a material of negative dielectric permeability being provided above the active optical member, and electrically isolated from the first layer (112).

10. Photosensitive matrix including a plurality of photodetectors, **characterised in that** said photodetectors are devices according to any of claims 8 and 9.

11. Device according to any of claims 1 to 7, **characterised in that**:

- the medium of positive dielectric permeability is a semi-conductor type material,
- said active optical member is an active layer (210) of said material allowing an optical gain and a laser emission,
- the period $\Lambda$, multiplied by the refractive index of the layer 20, is close to the wavelength emitted,
- said device allows a vertical extraction of the laser emission.

12. Device according to claim 11 in combination with claim 4 or 7, **characterised in that** the parameters a, b, c, d and $h_g$ of said optical structure are chosen so that the second harmonic of $2^{nd}$ order (g(x,y,$\frac{1}{2}\Lambda$)) of Fourier series associated to the profile of the unit pattern has a complex amplitude ($\beta$) much higher than the complex amplitude ($\alpha$) of the harmonic of $1^{st}$ order (f(x,y,$\Lambda$)).

13. Device according to claim 11 or 12, **characterised in that** it further includes at least a layer (211) having an optical index lower than the refractive index of the active layer (210).

14. Photo-emitting matrix including a plurality of photo-emitting devices of a laser beam made on a same substrate (S), **characterised in that** said photo-emitting devices are devices according to any of claims 11 to 13.

15. Device according to any claims 1 to 7, **characterised in that**:

- the medium of positive dielectric permeability is a semi-conductor type material,
- said material including an active optical member made up of a layer (300) of a non linear material transparent to wavelengths of an infrared and terahertz range, said layer (300) including a non linear waveguide (301) transparent to said wavelengths, and having a positive dielectric permeability higher than that of said layer (300),
- the period $\Lambda$, multiplied par an average refractive index of said layer (300), has a value close to a terahertz wavelength,
- said device allowing a vertical emission of a terahertz wave at said terahertz wavelength, generated through conversion of optical frequency, in response to an illumination of the waveguide along the 0x axis under first and second optical frequencies ($\omega_1$, $\omega_2$) different from the near infrared domain.

16. Device according to claim 15, in combination with claim 4 or 7, **characterised in that** the parameters a, b, c, d and $h_g$ of the optical structure are chosen so that the second harmonic of $2^{nd}$ order (g(x,y,½Λ)) of the Fourier series associated to the profile of the unit pattern has a complex amplitude ($\beta$) much higher than the complex amplitude ($\alpha$) of the harmonic of $1^{st}$ order (f(x,y,Λ)).

17. Device according to any of claims 1 to 7, **characterised in that** it includes at least an optical member, and **in that**

- said medium of positive dielectric permeability is vacuum;
- said active optical member is an electron emitter (510) with a tip effect, emitting along the -0y axis, the electron emission being controlled by an optical wave,
- the period A of the optical structure (500) is close to the wavelength of said optical wave.

18. Device according to claim 17, **characterised in that** said emitter includes a photoconducting member disposed in the vicinity of the optical structure, the electron emission being controlled by the photoconductivity of said member.

19. Device according to claim 18, **characterised in that** said emitter (510) includes a nanowire or nanotube, oriented along -Oy, of a photosensitive conducting material, which constitutes said photoconducting member.

20. Device according to any of claims 17 to 19, **characterised in that** said emitter is disposed in the vicinity of the plane of symmetry ($\Pi$), at a distance from said plane along 0x in the order of A/4.

21. Device according to any of claims 17 to 20, **characterised in that** it includes first and second emitters disposed on either side of the plane of symmetry ($\Pi$), each one at about A/4 from said plane along 0x.

22. Device according to any claim 17 to 21, **characterised in that** it includes a plurality of electron emitters aligned along 0z, in said third area.

23. Device according to any of claims 17 to 22, **characterised in that** the electron emission is controlled by the electrical field of the optical wave, the optical structure resulting in a re-orientation of this electrical field in the emission axis of the emitter, **in that** said electron emitter includes a carbon nanotube or a semi-conducting or metal nanowire, and **in that** it includes first and second incident optical sources, for generating a terahertz signal.

24. Electron source emission with an optical modulation of electrical field including an electron beam emission device according to any of claims 17 to 23.

EP 1 946 387 B1

FIG.1

FIG.2

FIG.3

FIG.4

EP 1 946 387 B1

FIG.5a

FIG.5b

EP 1 946 387 B1

FIG.6

FIG.7

EP 1 946 387 B1

FIG.8a

FIG.8b

FIG.8c

EP 1 946 387 B1

FIG.9

FIG.10a

FIG.10b

FIG.10c

FIG.10d

FIG.10e

FIG.10f

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2863774
- EP 1466393 A

- FR 0413340

**Littérature non-brevet citée dans la description**

- *IEEE Transaction on Microwave Theory and Techniques,* Octobre 2004, vol. 52 (10